# EUROPEAN PATENT APPLICATION

(11) **EP 1 566 845 A1**
(43) Date of publication of application: **24.08.2005**
(21) Application number: 03751417.1
(22) Date of filing: 09.10.2003
(51) Int. Cl.: H01L 31/04

(54) **PHOTOELECTRIC CONVERSION ELEMENT**

(30) Priority: 28.11.2002 JP 2002346304; 18.12.2002 JP 2002367286
(71) Applicant: Nippon Oil Corporation, Tokyo 105-8412 (JP)
(72) Inventor: NISHIKITANI, Yoshinori c/o NIPPON OIL CORPORATION, Yokohama-shi, Kanagawa 231-0815 (JP); ASANO, Tsuyoshi c/o NIPPON OIL CORPORATION, Yokohama-shi, Kanagawa 231-0815 (JP); UCHIDA, Souichi c/o NIPPON OIL CORPORATION, Yokohama-shi, Kanagawa 231-0815 (JP)
(74) Representative: Modin, Jan
(86) International application number: PCT/JP2003/012963
(87) International publication number: WO 2004/049458

(57) **Abstract**

Photoelectric converting devices used for photovoltaic power generation or a photovoltaic power generating system have a photoelectric converting layer comprising an organic compound (A) having both an electron donating molecular structure and an electron accepting molecular structure dispersed in the polymer and/or an organic compound (B) having an electron donating molecular structure and an organic compound (C) having an electron accepting molecular structure, dispersed in a polymer. The photoelectric converting devices are suppressed in the phase separation of the photoelectric converting layer and thus is enhanced in light utilizing efficiency.

## Description

### [Field of the Invention]

The present invention relates to photoelectric converting devices useful for photovoltaic generators or photovoltaic generating systems.

### [Background of the Invention]

In recent years, due to an increased awareness of environmental issues, attention has been attracted to solar energy which is an inexpensive and clean energy source as an alternative for fossil fuels causing carbon dioxide emission having an affect on the global warming. Conversion of solar energy to other energies such as electric energy is important for the effective use of solar energy. In this connection, inorganic semiconductor-type photoelectric generators, such as silicon have been developed and put to practical use. However, since such photoelectric generators are enormous in energy consumption for the production thereof, it has been desired to develop a photoelectric converting device which can be produced with a low energy and cost consumption.

Organic compounds are inexpensive and give less affect to the environment even though being disposed by incineration after use. With this background in view, development of a photoelectric converting device using organic photoelectric converting substances is one of the most important energy measures.

Interests to the photoelectric converting device using organic substances have been increased since the Tang's converting device exhibited about 1 percent efficiency in 1986 (C. W. Tang. Appl. Phys. Lett., Vol. 48, pages 183-185, January 13, 1986). Thereafter, the photoelectric converting efficiency has been improved year by year. For enhancing the efficiency of the organic photoelectric converting device, it is necessary to establish a combination of an electron-donating organic semiconductor (donor) and an electron-accepting organic semiconductor (acceptor), a so-called heterojunction structure. An effective charge separation occurs in the proximity of the interface between the donor and the acceptor. Based on such an idea, for example, U. S. Patent Nos. 5,454,880 and 5, 331, 183 proposed a so-called bulk heterojunction wherein an electric conductive polymer as a donor and a fullerene derivative as an acceptor are mixed, thereby developing a photoelectric converting device with a higher density donor/acceptor interface, resulting in an enhanced photoelectric converting efficiency. Therefore, the key factor in development of an organic photoelectric converting device in recent years is how the charge separation interface between the donor and the acceptor is designed.

For developing a photoelectric converting device with an enhanced photoelectric converting efficiency, it is also important to transport efficiently carriers (electrons, holes) generated after charge separation. Friend et al. succeeded in establishing a structure with a high carrier mobility efficiency by using an electron-donating benzocoronen and an electron-accepting perylene dye, stacking by self-organization (Science, Vol. 293, pages 1119-1122, August 10, 2001). Stacking of π conjugated systems exhibits a large carrier mobility with respect to the lamination direction.

However, a strong tendency that molecules are self-organized causes the molecules of donors and acceptors to gather with the same ones, respectively upon production of a photoelectric converting device, resulting in the possibility of phase separation. When the separation occurs, a rugged surface is formed on the photoelectric converting layer, leading to a reduction of the photoelectric converting efficiency.

The present invention was made in view of the above-described circumstances and thus relates to a photoelectric converting material enabling a production of a photoelectric converting layer excellent in a capability to suppress the phase separation and also to a photoelectric converting device using the photoelectric converting material.

### [Disclosures of the Invention]

As a result of the studies by the inventors of the present invention, the present invention was achieved based on the finding that an photoelectric converting device with excellent properties that it is suppressed in the phase separation of the photoelectric converting layer and thus enhanced in the light utilizing efficiency can be produced by dispersing a specific compound in a polymer forming the photoelectric converting layer.

That is, the present invention relates to a photoelectric converting device which has a photoelectric converting layer comprising an organic compound (A) having both an electron donating molecular structure and an electron accepting molecular structure dispersed in a polymer.

The present invention also relates to a photoelectric converting device which has a photoelectric converting layer comprising an organic compound (B) having an electron donating molecular structure and an organic compound (C) having an electron accepting molecular structure, dispersed in a polymer.

The present invention will be described below in more detail.

First of all, described will be a polymer constituting the photoelectric converting layer of the photoelectric converting device of the present invention. No particular limitation is imposed on the polymer as long as it can disperse an organic compound (A) having both an electron donating molecular structure and an electron accepting molecular structure (hereinafter referred to as Compound (A))or both an organic compound (B) having an electron donating molecular structure (hereinafter referred to as Compound (B)) and an organic compound (C) having an electron accepting molecular structure (hereinafter referred to as Compound (C)). Examples of the polymer include acrylic polymers such as polymethylmethacrylate and polyethylacrylate; polyethers such as polyethylene oxide and polypropylene oxide; polyesters such as polyethylene terephthalate; electrically conductive polymer compounds such as polyphenylene vinylene, polyacetylene, polythiophene, and polypyrrole. More preferred among these compounds are electrically conductive polymer compounds. Preferred electrically conductive polymer compounds are those having an electric conductivity of generally 10⁻⁶ to 10⁶ S/cm and more preferably 10⁻⁴ to 10⁵ S/cm, at a temperature of 20°C.

No particular limitation is imposed on the molecular weight of the polymer as long as it can disperse Compound (A) or Compounds (B) and (C) and can form a photoelectric converting layer, and thus the molecular weight is suitably selected. Therefore, the polymer may be any of those having a molecular weight of usually 1,000 to 5,000,000, preferably 10,000 to 1,000,000 and more preferably 50,000 to 500,000.

No particular limitation is imposed on the content of Compound (A) having both an electron donating molecular structure and an electron accepting molecular structure as long as the present invention is not prevented from achieving the object thereof. However, the content of Compound (A) is usually from 5 to 300 parts by mass, preferably 10 to 100 parts by mass and more preferably 20 to 80 parts by mass, based on 100 parts by mass of the polymer.

No particular limitation is imposed on the content of Compound (B) having an electron donating molecular structure or Compound (C) having an electron accepting molecular structure as long as the present invention is not prevented from achieving the object thereof. The content of Compound (B) having an electron donating molecular structure is usually from 5 to 300 parts by mass, preferably 10 to 100 parts by mass and more preferably 20 to 80 parts by mass, based on 100 parts by mass of the polymer while the content of Compound (C) having an electron accepting molecular structure is usually from 5 to 300 parts by mass, preferably 10 to 100 parts by mass and more preferably 20 to 80 parts by mass, based on 100 parts by mass of the polymer. No particular limitation is imposed on the ratio of Compound (B) having an electron donating molecular structure to Compound (C) having an electron accepting molecular structure. However, the mass ratio between Compounds (B) and (C) is usually from 10/90 to 90/10 and preferably 20/80 to 80/20.

The term "electron-donating molecular structure" used herein denotes a structure exhibiting properties that the molecules are small in ionization potential and likely to become positive ions per se by supplying electrons to other molecules, while the term "electron-accepting molecular structure" denotes a structure exhibiting properties that the molecules are large in electron affinity and likely to become negative ions per se by accepting electrons from other molecules.

When a compound (A) having both an electron-donating molecular structure and an electron-accepting molecular structure is used in the present invention, the above-described electron-donating and electron-accepting properties are determined automatically depending on the relative relationship between their structures having such properties in the compound (A). Therefore, combinations of such structures that fulfill these properties are arbitrarily selected.

When a compound (B) having an electron-donating molecular structure is used in combination with a compound (C) having an electron-accepting molecular structure, the above-described electron-donating and electron-accepting properties are determined automatically depending on the relative relationship between the compounds to be used. Therefore, combinations of such compounds that fulfill these properties are arbitrarily selected.

No particular limitation is imposed on the molecular structure having electron-donating properties as long as it has electron-donating properties in the molecular structure portion. Examples of the structure include amine, metallocene, polyarylene vinylene, polyanyline, polythiophene, polypyrrole and polyamine structures.

No particular limitation is imposed on the molecular structure having electron-accepting properties as long as it has electron-accepting properties in the molecular structure portion. Examples of the structure include viologen, perylene and fullerene structures.

Specific examples of the molecular structures having electron-accepting properties include those represented by formulas (1) to (18) below, while specific examples of the molecular structures having electron-donating properties include those represented by formulas (19) to (61) below:

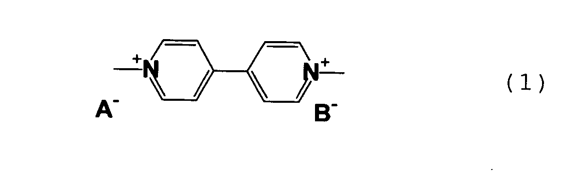

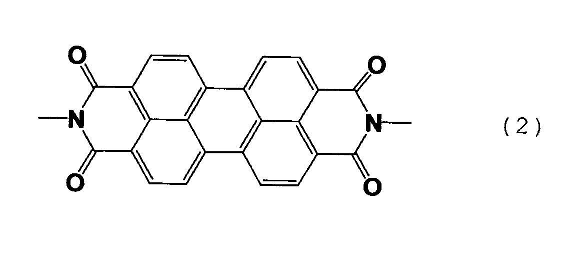

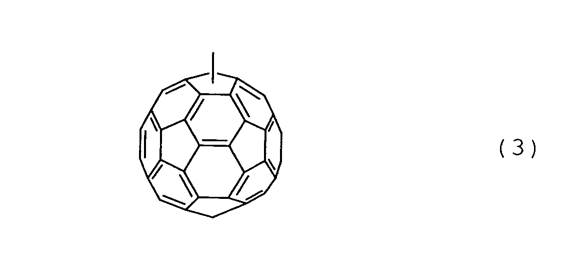

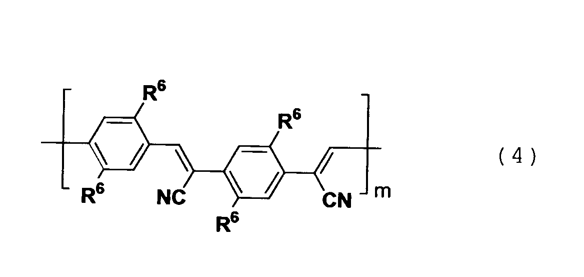

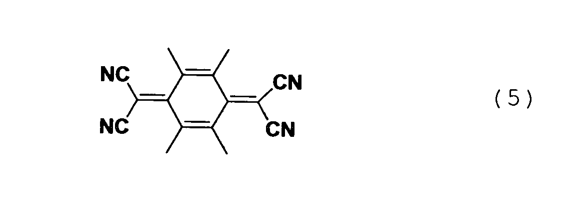

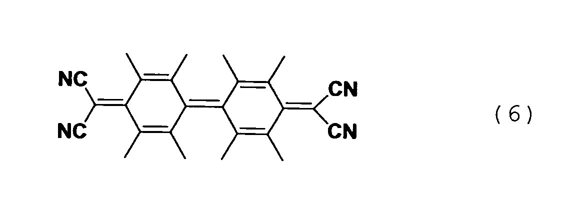

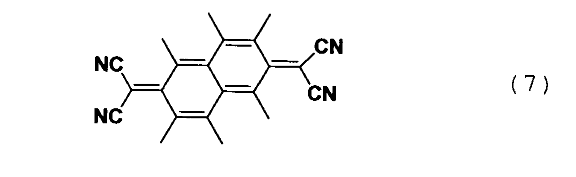

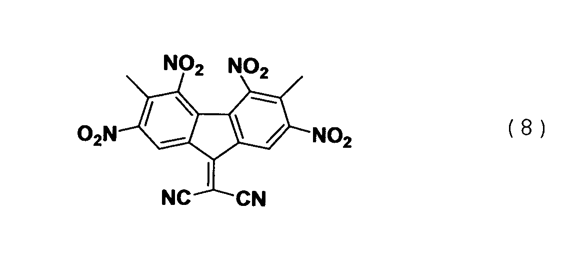

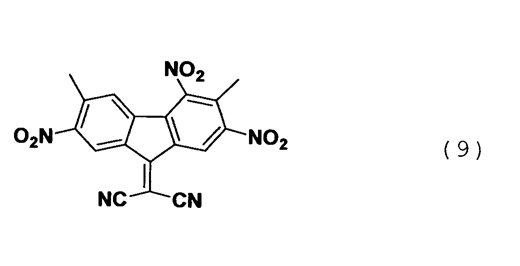

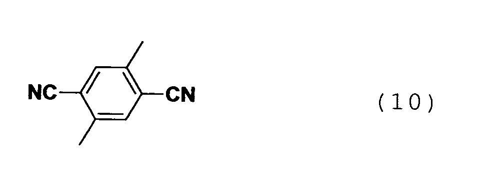

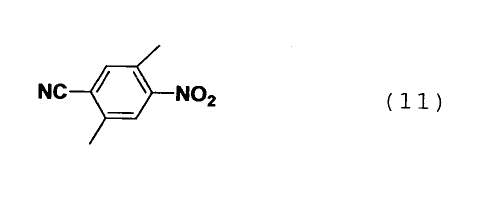

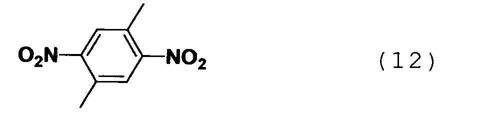

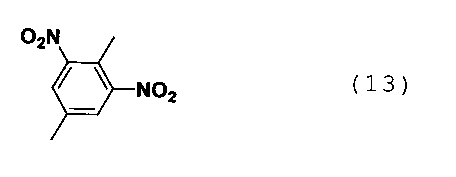

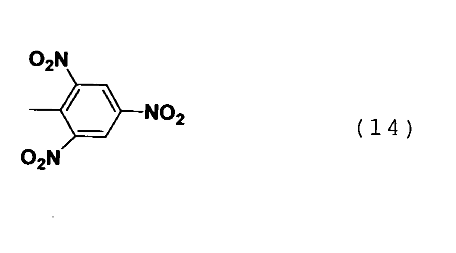

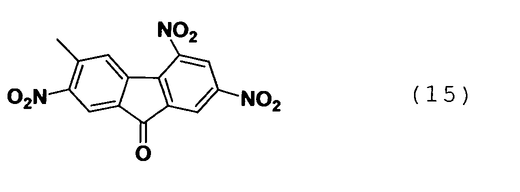

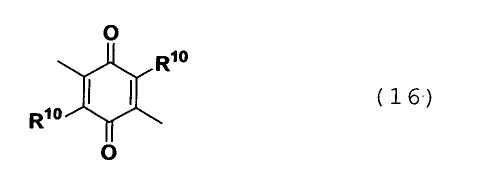

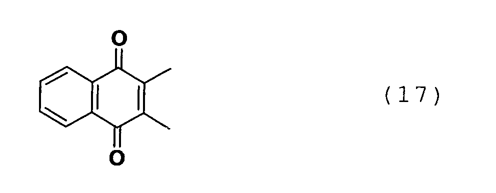

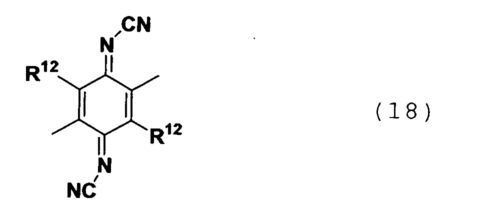

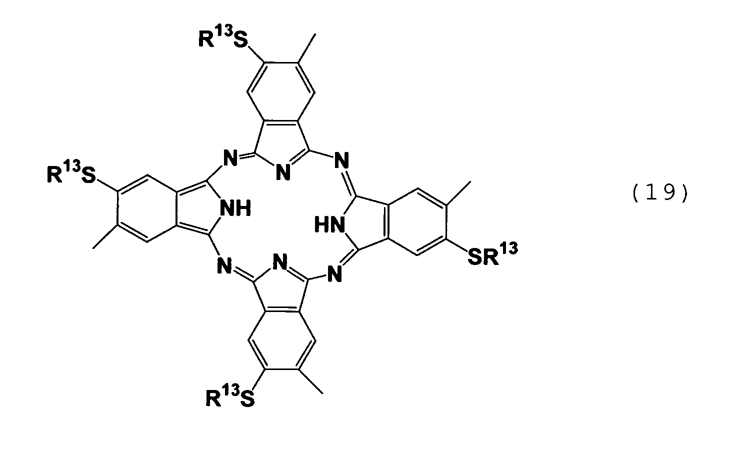

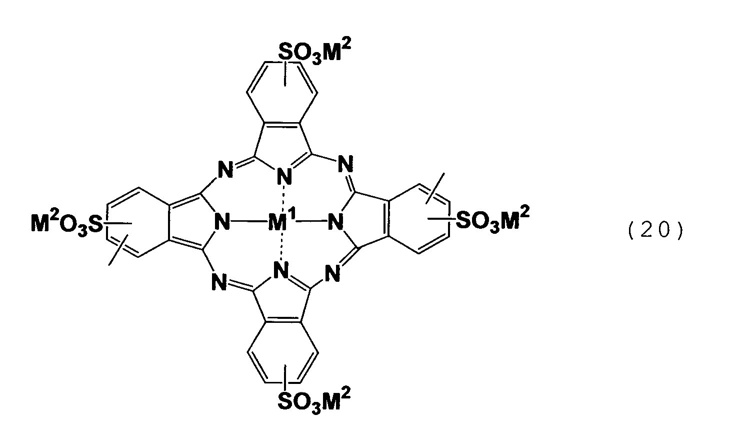

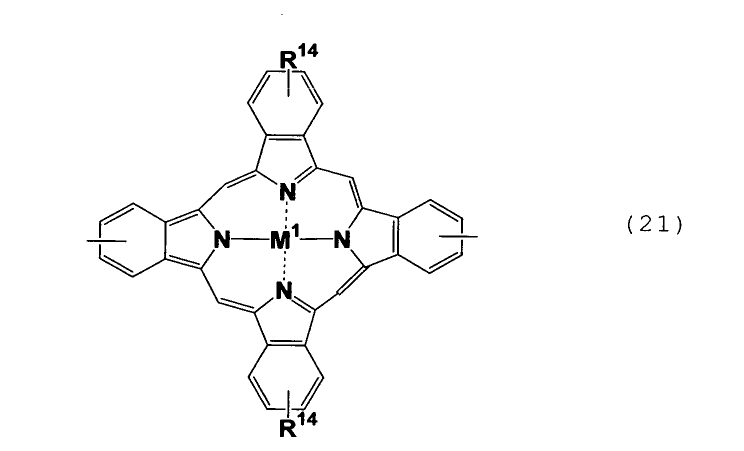

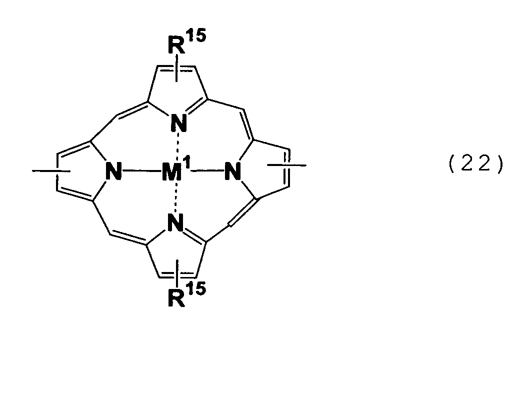

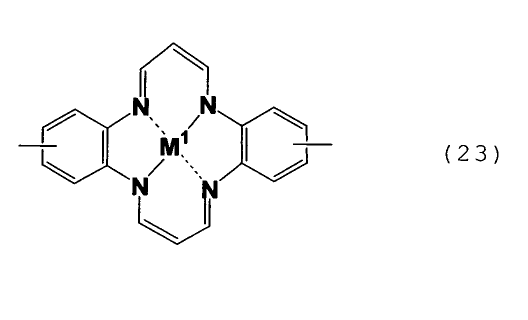

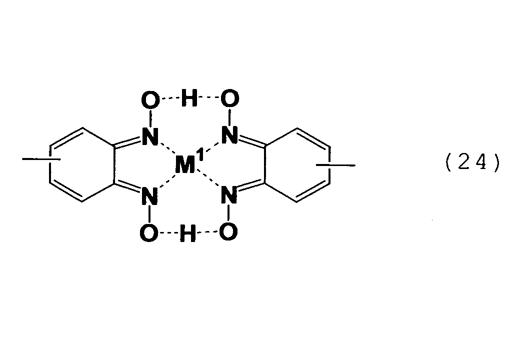

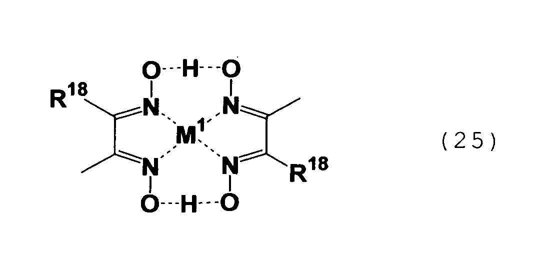

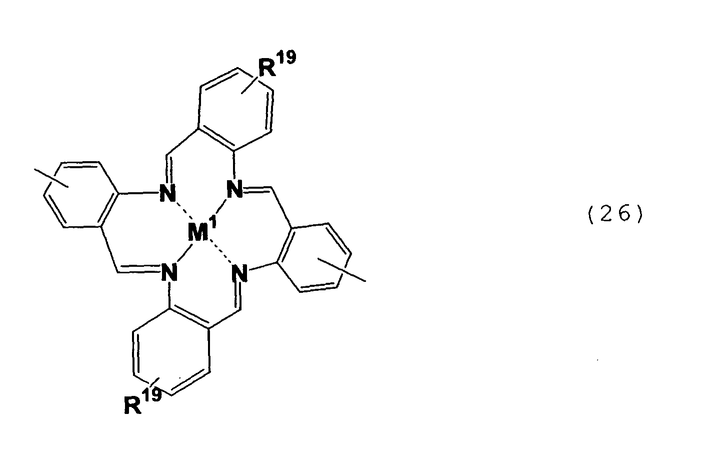

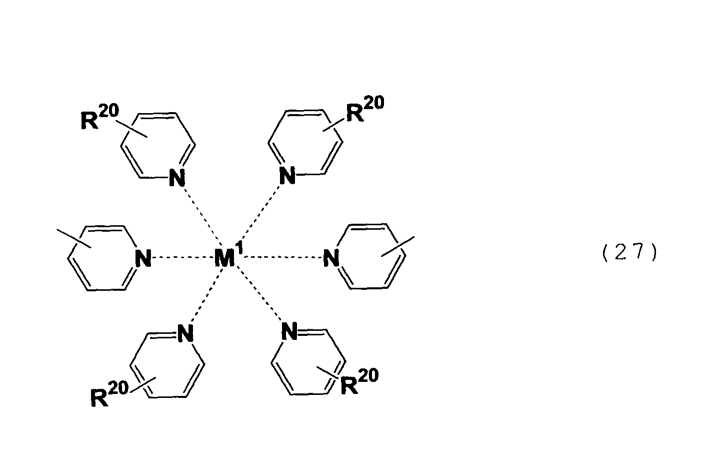

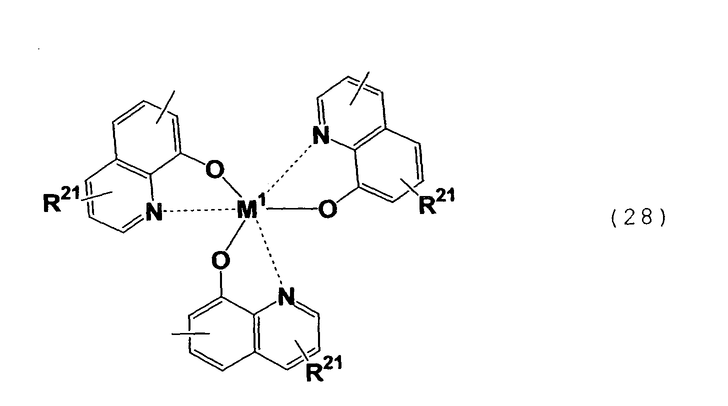

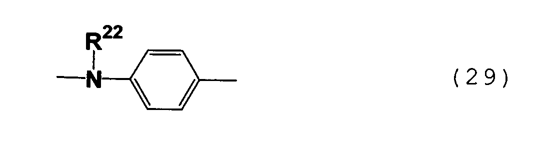

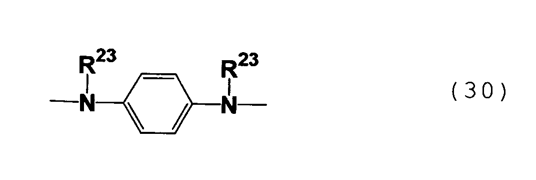

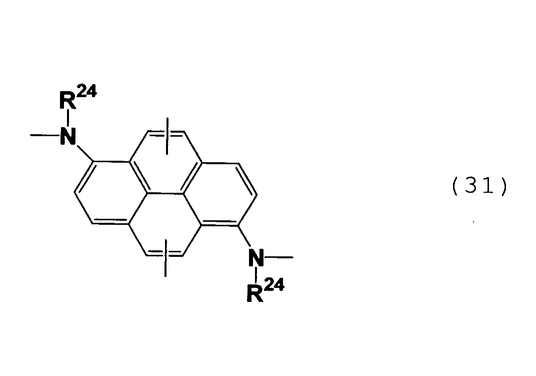

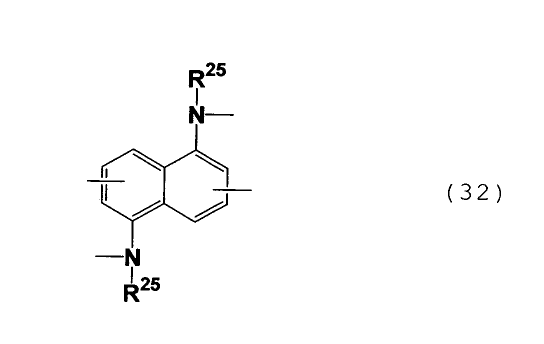

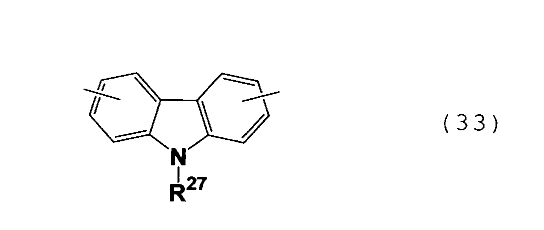

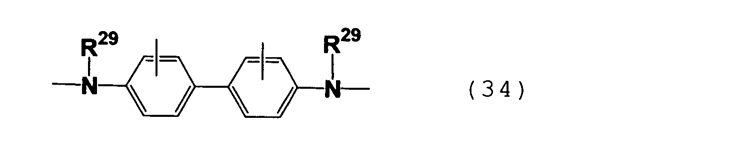

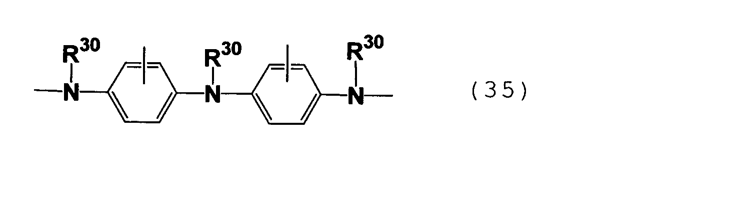

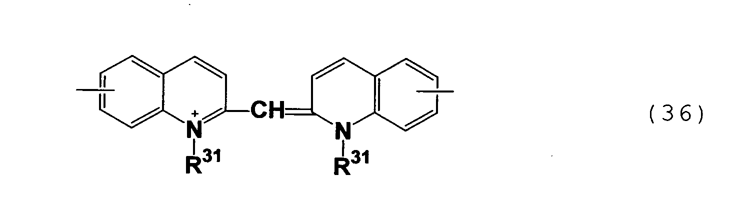

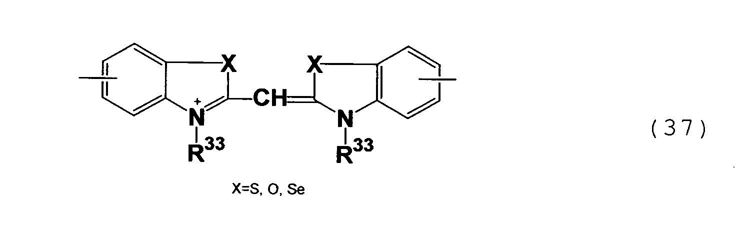

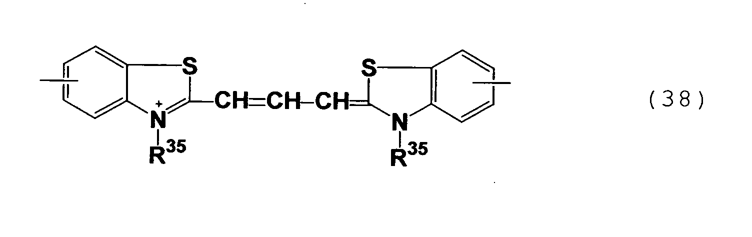

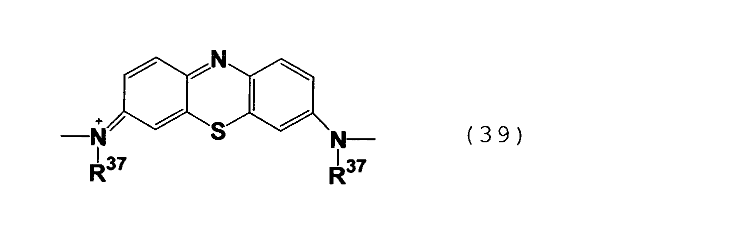

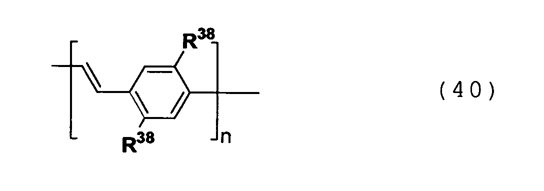

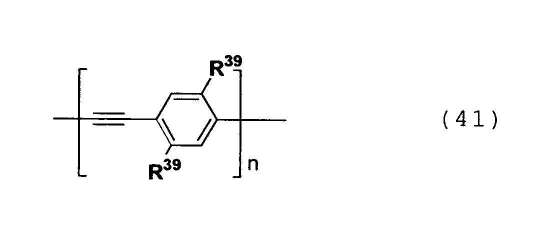

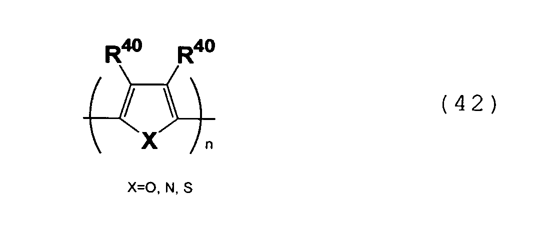

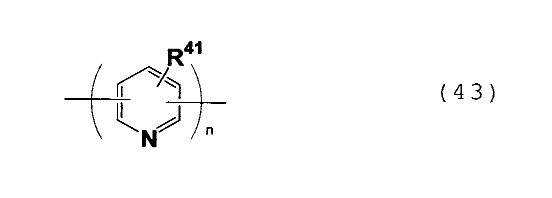

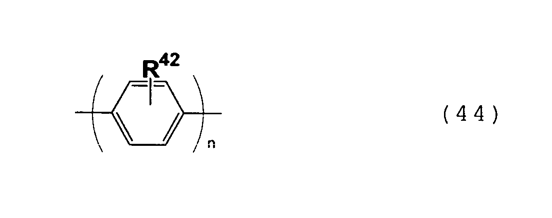

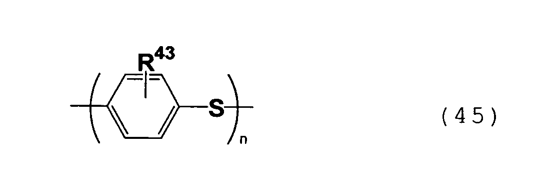

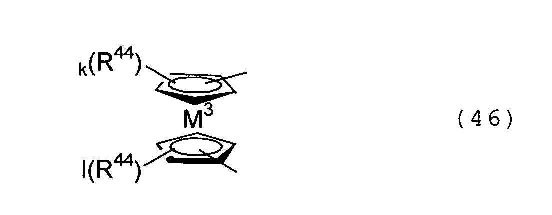

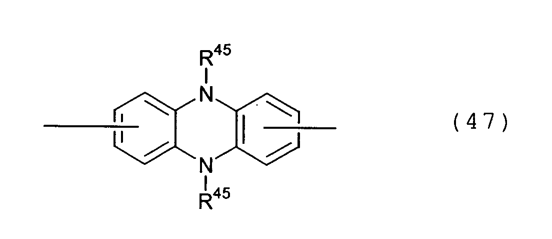

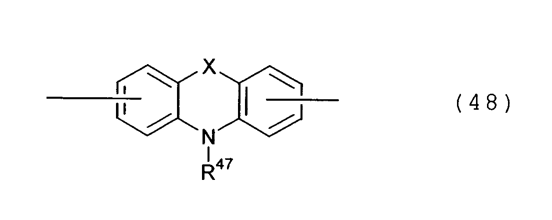

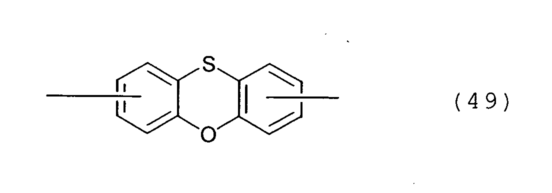

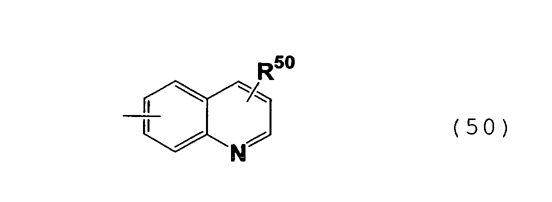

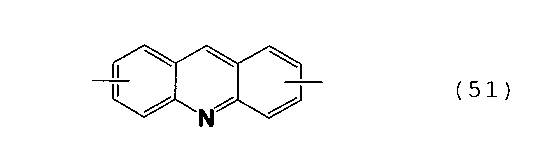

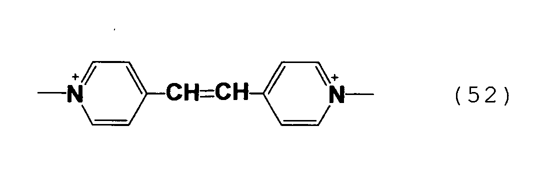

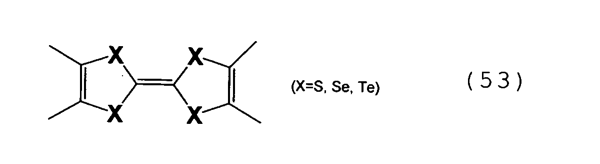

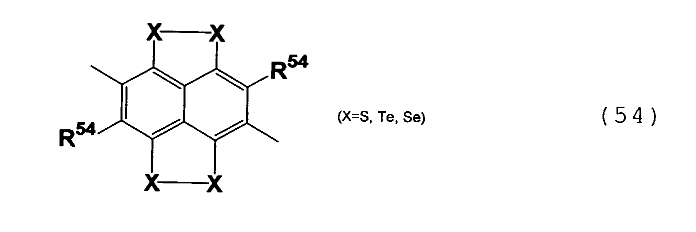

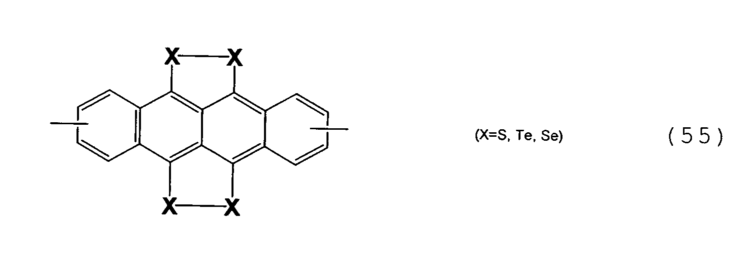

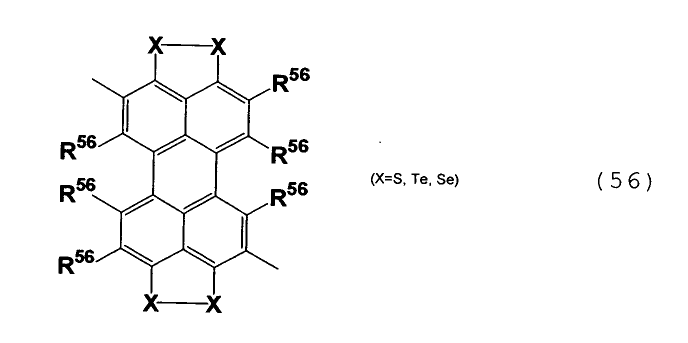

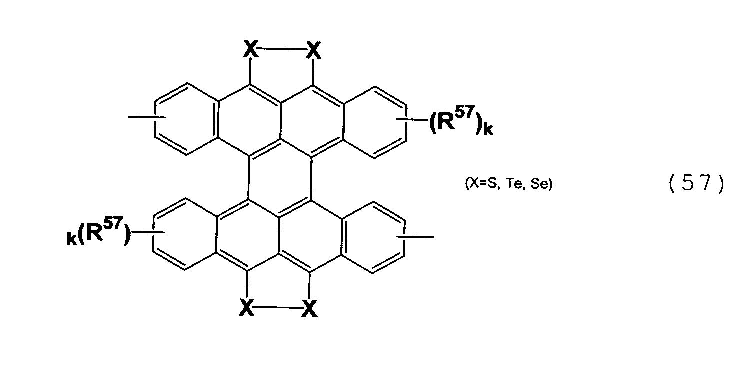

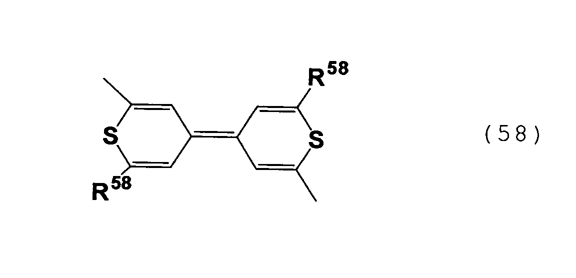

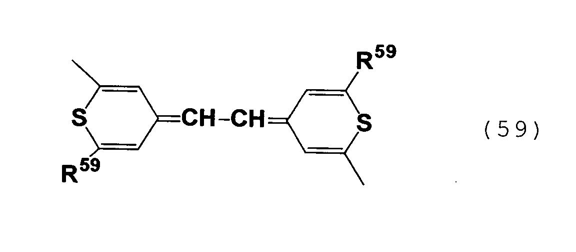

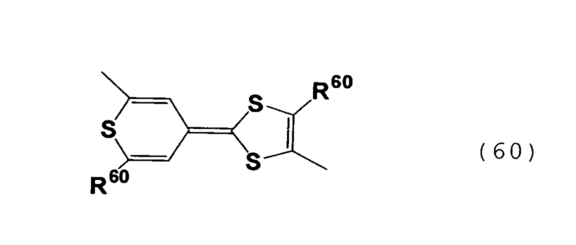

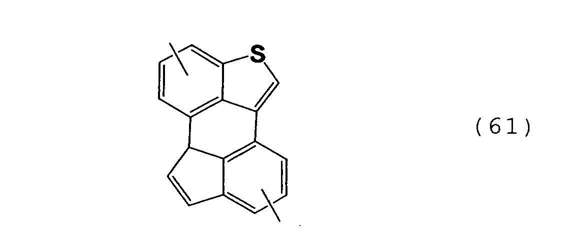

In formulas (1) to (61), R⁶ to R⁶⁰ (excluding R¹⁰ and R¹²) may be the same or different from each other and are each independently hydrogen; a straight-chain or branched alkyl, alkenyl or alkoxyl group each having 1 to 10 carbon atoms; or an aryl, aralkyl, or aryloxy group having 6 to 12 carbon atoms. R⁴⁴ may bond to a cyclopentadienyl ring so as to form a ring or may form a group crosslinking cyclopentadienyl rings which are different from each other.

R¹⁰ and R¹² may the same or different from each other and are each independently hydrogen, halogen, a cyano, nitro, hydroxyl, amino, carboxyl, acetyl, or formyl group, a straight-chain or branched alkyl, alkenyl, alkoxyl, alkylthio or alkyloxycarbonyl group having 1 to 10 carbon atoms, or an aryl, aralkyl, or aryloxy group having 6 to 12 carbon atoms.

When a plurality of R⁶ to R⁶⁰ groups exist in one of the formulas they may be the same or different from each other.

A⁻ and B⁻ may be the same or different from each other and are each independently a counter anion selected from the group consisting of halogen anions, ClO₄⁻, BF₄⁻, PF₆⁻, CH₃COO⁻, and CH₃(C₆H₄)SO₃⁻.

In the above formulas, m and n are each independently an integer of 1 to 1,000, preferably 2 to 500, and k and 1 indicate the number of each cyclic hydrocarbon group which can be substituted and are each usually an integer of 0 to 4.

M¹ is a metal atom such as Cu, Zn, Co, Fe, Ti, Mg, Ni, Mo, Os, and Ru. M² is an alkali metal or alkaline earth metal such as Li, Na, Mg, and Ca. M³ is Cr, Co, Fe, Mg, Ni, Os, Ru, V, X-Hf-Y, X-Mo-Y, X-Nb-Y, X-Ti-Y, X-V-Y or X-Zr-Y wherein X and Y are each independently hydrogen, halogen or an alkyl group having 1 to 12 carbon atoms and may be the same or different from each other.

Examples of the alkyl group include methyl, ethyl, propyl, i-propyl, butyl, s-butyl, t-butyl, pentyl, isopentyl, neopentyl, t-pentyl, hexyl, isohexyl, heptyl, octyl, nonyl, and decyl groups. Examples of the alkenyl group include vinyl, allyl, isopropenyl, butylenyl, pentylenyl, and hexenyl group. Examples of the alkoxy group include methoxy, ethoxy, propoxy, i-propoxy, butoxy, s-butoxy, t-butoxy, pentoxy, isopentoxy, neopentyloxy, t-pentyloxy, hexyloxy, isohexyloxy, heptyloxy, octyloxy, nonyloxy, and decyloxy groups. Examples of the aryl group include phenyl, xylyl, tolyl, cumenyl, and naphthyl groups. Examples of the aralkyl group include benzyl and trimethyl. Examples of the aryloxy group include phenoxy and tolyloxy groups.

In the compound having both an electron-donating molecular structure and an electron-accepting molecular structure, the above-described electron-donating molecular structure and electron-accepting molecular structure chemically bond to each other via covalent bond or ion bond. Examples of the covalent bond include those by a hydrocarbon group having 1 to 20 and preferably 1 to 10 carbon atoms, specific examples of which include hydrocarbon groups such as alkylene groups, hydrocarbon groups containing an ester bond, hydrocarbon groups containing an ether bond, hydrocarbon groups containing an amide bond, hydrocarbon groups containing a thioether bond, hydrocarbon groups containing an amine bond, hydrocarbon groups containing a urethane bond, and hydrocarbon groups containing a silyl bond.

Preferred combinations of the electron-accepting molecular structure and the electron-donating molecular structure are a fullerene derivative (formula (3)) and a poly(phenylenevinylene)derivative (formula (40)); a cyano group-containing poly(phenylenevinylene)derivative (formula (4)) and a poly(phenylenevinylene)derivative (formula (40)); a viologen derivative (formula (1)) and an amine derivative (formulas (29) to (35)); a viologen derivative (formula (1)) and a metallocene derivative (formula (46)); a viologen derivative (formula (1)) and a polythiophene derivative (formula (42)); a viologen derivative (formula (1)) and a polypyrrole derivative (formula (42)); a viologen derivative (formula (1)) and a poly(phenylenevinylene)derivative (formula (40)); a perylene derivative (formula (2)) and a copper phthalocyanine derivative (formulas (20) to (22)); a perylene derivative (formula (2)) and a phthalocyanine derivative (formula (19)); a perylene derivative (formula (2)) and an amine derivative (formulas (29) to (35)); a perylene derivative (formula (2)) and a poly(phenylenevinylene)derivative (formula (40)); a perylene derivative (formula (2)) and a polythiophene derivative (formula (42)); a perylene derivative (formula (2)) and a polypyrrole derivative (formula (42)); a perylene derivative (formula (2)) and a metallocene derivative (formula (46)); a fullerene derivative (formula (3)) and a copper phthalocyanine derivative (formulas (20) to (22)); a fullerene derivative (formula (3)) and an amine derivative (formulas (29) to (35)); a fullerene derivative (formula (3)) and a polythiophene derivative (formula (42)); a fullerene derivative (formula (3)) and a polypyrrole derivative (formula (42)); a fullerene derivative (formula (3)) and a metallocene derivative (formula (46)); a cyano group-containing poly(phenylenevinylene)derivative (formula (4)) and an amine derivative (formulas (29) to (35)); a cyano group-containing poly(phenylenevinylene)derivative (formula (4)) and a copper phthalocyanine derivative (formulas (20) to (22)); a cyano group-containing poly(phenylenevinylene)derivative (formula (4)) and a polythiophene derivative (formula (42)); a cyano group-containing poly(phenylenevinylene)derivative (formula (4)) and a polypyrrole derivative (formula (42)); and a cyano group-containing poly(phenylenevinylene)derivative (formula (4)) and a metallocene group (formula (46)).

Examples of compounds containing such combinations include those represented by formulas (62) to (66) given below:

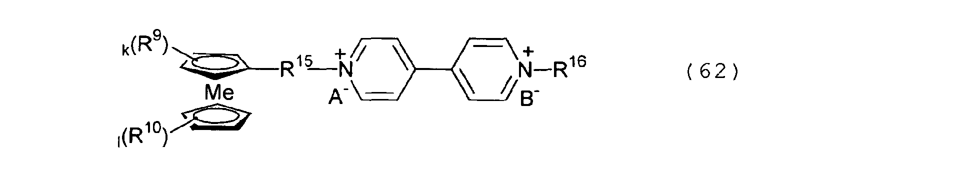

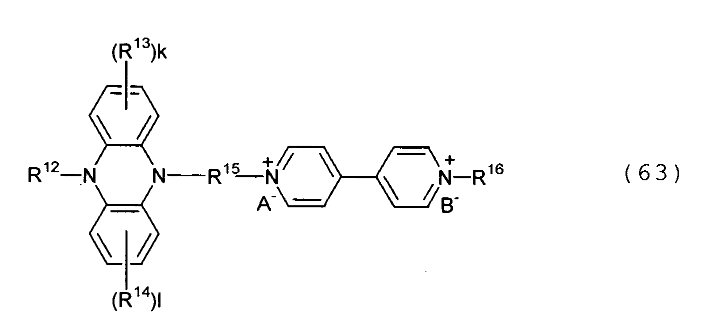

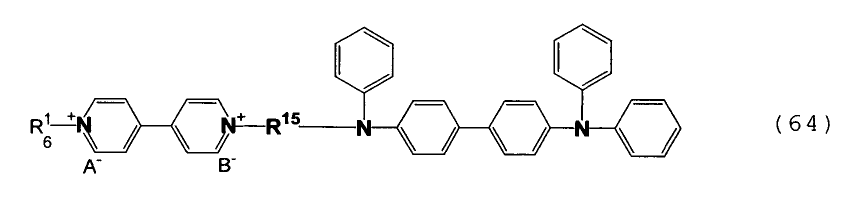

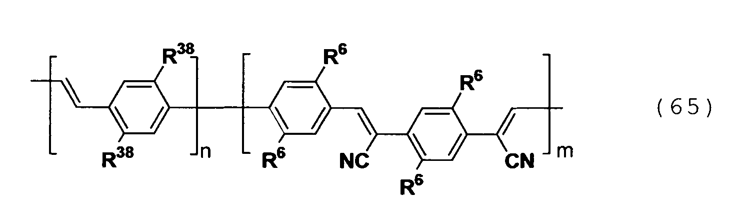

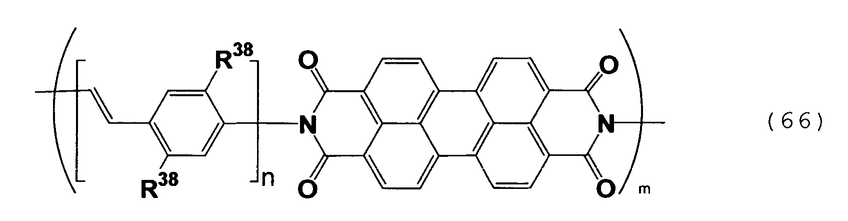

In formulas (62) to (66), R⁶, R⁹, R¹⁰, R¹² to R¹⁴, R¹⁶, and R³⁸ may be the same or different from each other and are each independently a straight-chain or branched alkyl, alkenyl, or alkoxyl group each having 1 to 10 carbon atoms or an aryl, aralkyl, aryloxy, or aralkyl group each having 6 to 12 carbon atoms. R¹⁵ is a divalent hydrocarbon group having 1 to 20 and preferably 1 to 10 carbon atoms. A⁻ and B⁻ may be the same or different from each other and are each independently a counter anion selected from the group consisting of halogen anions, ClO₄⁻, BF₄⁻, PF₆⁻, CH₃COO⁻, and CH₃(C₆H₄)SO₃⁻. In the above formulas, m and n are each independently an integer of 1 to 1,000 and preferably 2 to 500, and k and 1 indicate the number of each cyclic hydrocarbon group which can be substituted and are each usually an integer of 0 to 4.

Specific preferred examples of R¹⁵ in formulas (62) to (66) include hydrocarbon groups such as alkylene groups, hydrocarbon groups containing an ester bond, hydrocarbon groups containing an ether bond, hydrocarbon groups containing an amide bond, hydrocarbon groups containing a thioether bond, hydrocarbon groups containing an amine bond, hydrocarbon groups containing a urethane bond, and hydrocarbon groups containing a silyl bond.

Examples of the hydrocarbon group containing an ester bond include those represented by the formulas "-R-COO-R' -" and "-R-OCO-R' -" wherein R and R' are each independently an alkylene group having 1 to 8 carbon atoms. Examples of the hydrocarbon group containing an ether bond include those represented by the formula "-R-O-R'-" wherein R and R' are each independently an alkylene group having 1 to 10 carbon atoms. Examples of the hydrocarbon group containing an amide bond include those represented by the formulas "-R-CONH-R'-" and "-R-NHCO-R'-" wherein R and R' are each independently an alkylene group having 1 to 8 carbon atoms. Examples of the hydrocarbon group containing a thioether bond include those represented by the formula "-R-S-R'-" wherein R and R' are each independently an alkylene group having 1 to 10 carbon atoms. Examples of the hydrocarbon group containing an amine bond include those represented by the formulas "-R-NH-R' -" wherein R and R' are each independently an alkylene group having 1 to 10 carbon atoms and "-R-NH-Ph-" wherein R is an alkylene group having 1 to 10 carbon atoms and Ph is an arylene group or substituted arylene group having 6 to 12 carbon atoms. Examples of the hydrocarbon group containing a urethane bond include those represented by the formulas "-R-OCONH-R' -" and "-R-NHCOO-R' -" wherein R and R' are each independently an alkylene group having 1 to 8 carbon atoms. Examples of the hydrocarbon group containing a silyl bond include those represented by the formula "-R-Si (R")₂-R'-" wherein R and R' are each independently an alkylene group having 1 to 8 carbon atoms and R" is a methyl or ethyl group.

Specific preferred examples of these compounds include those represented by the following formulas:

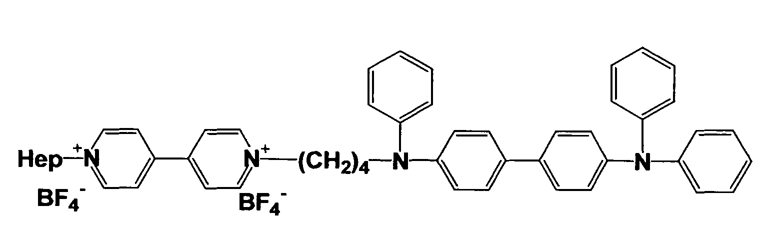

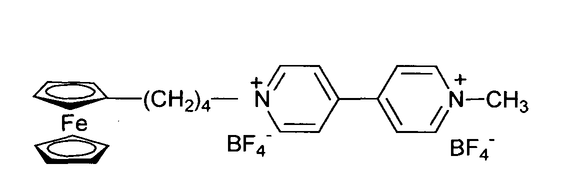

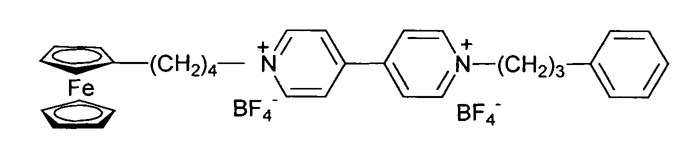

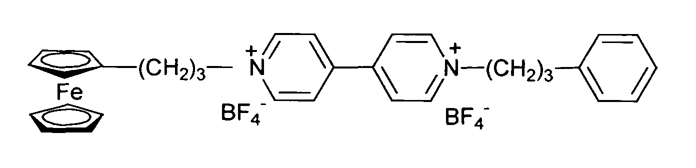

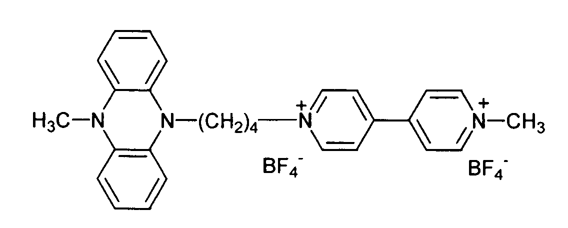

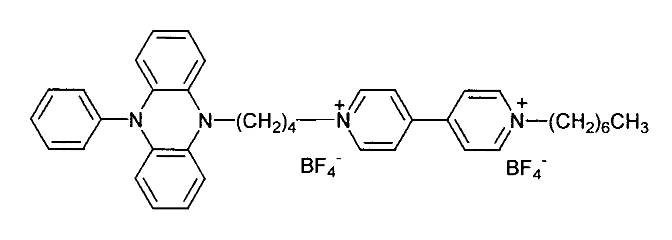

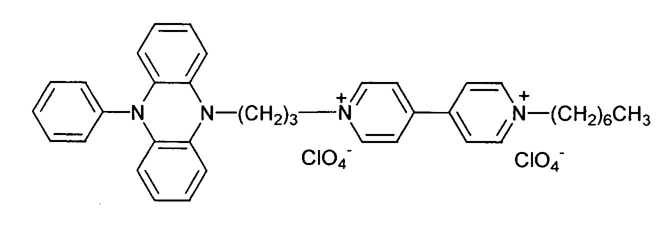

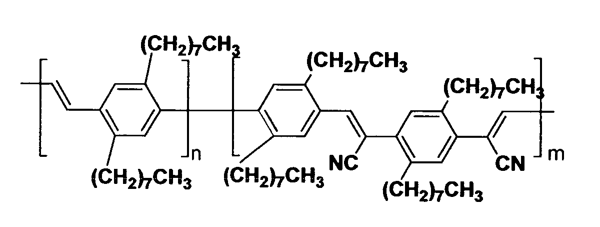

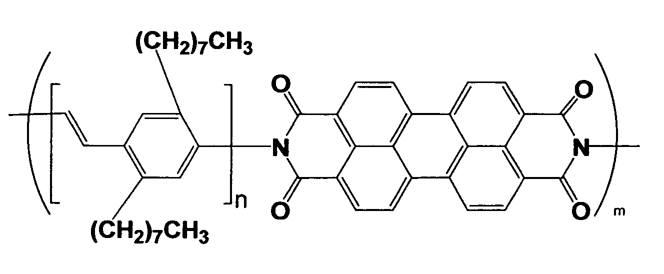

Specific examples of compounds having an electron-accepting molecular structure include those represented by formulas (1') to (18') below, while specific examples of compounds having an electron-donating molecular structure include those represented by formulas (19') to (61'):

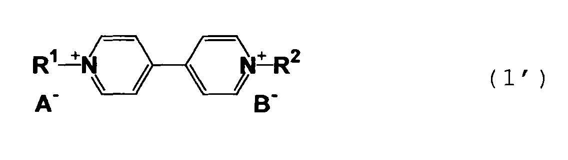

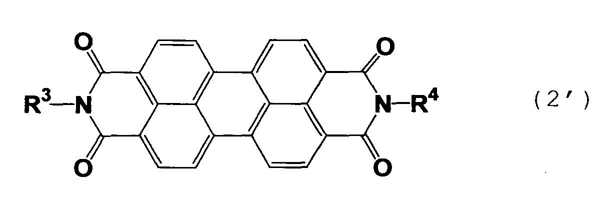

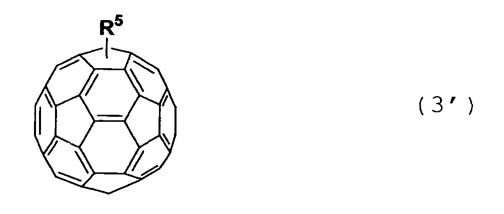

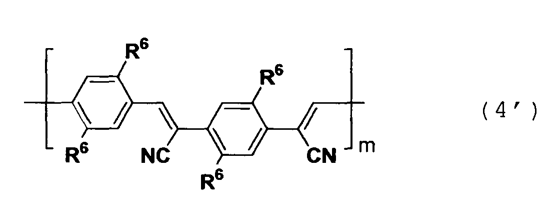

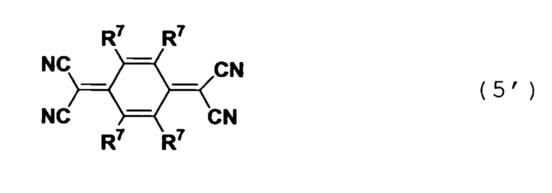

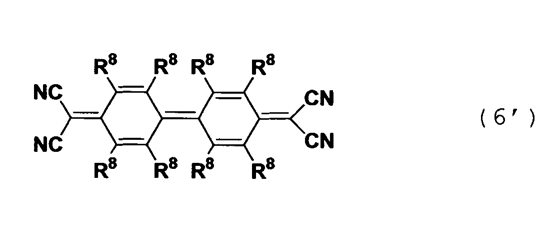

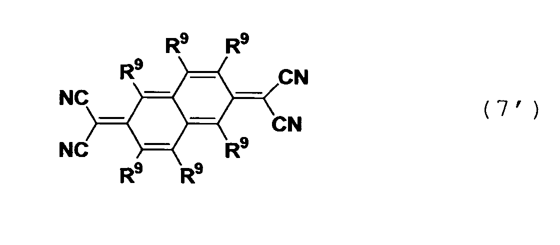

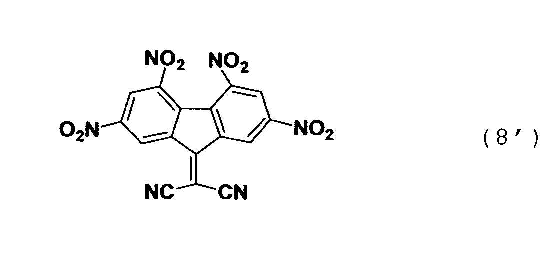

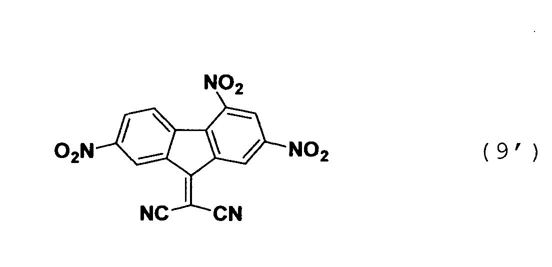

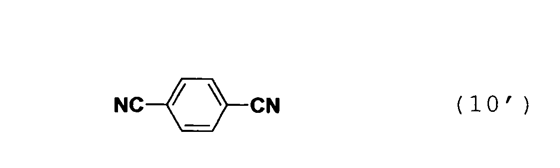

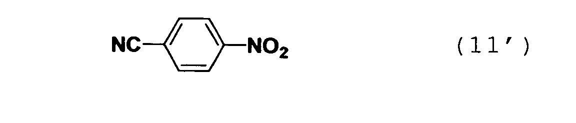

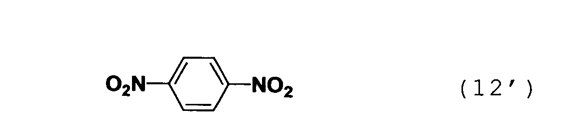

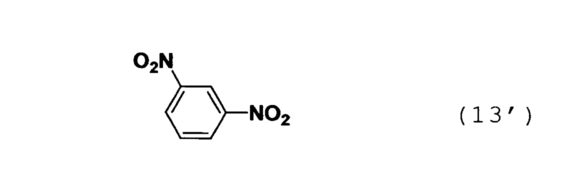

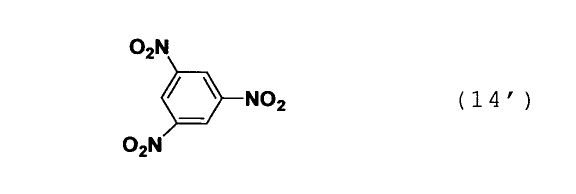

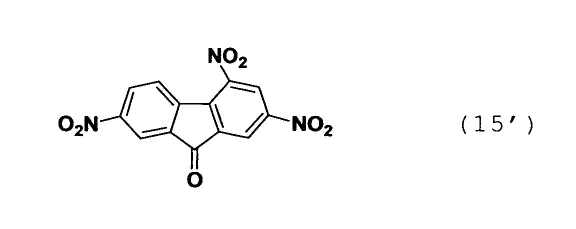

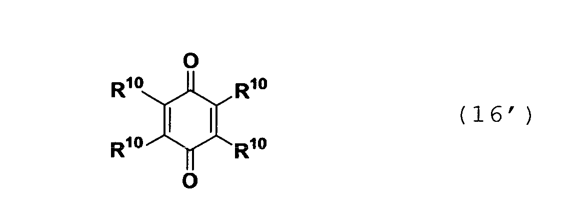

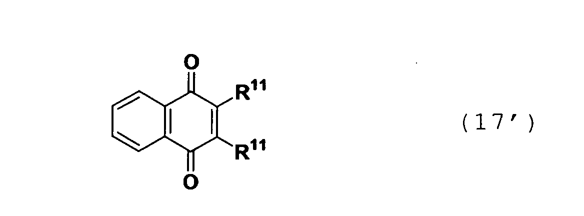

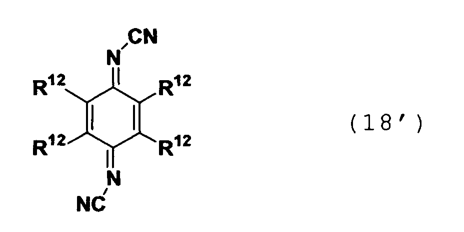

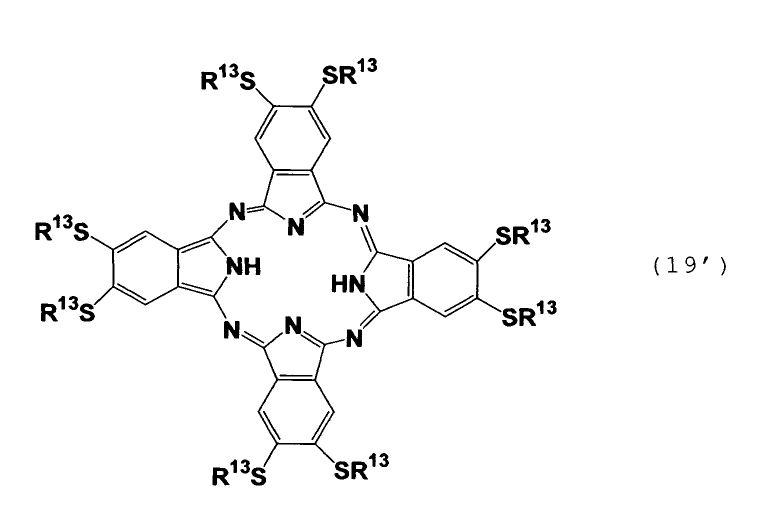

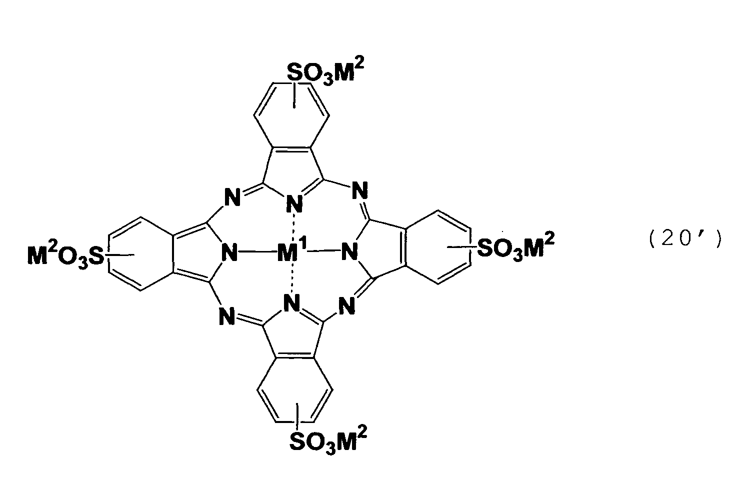

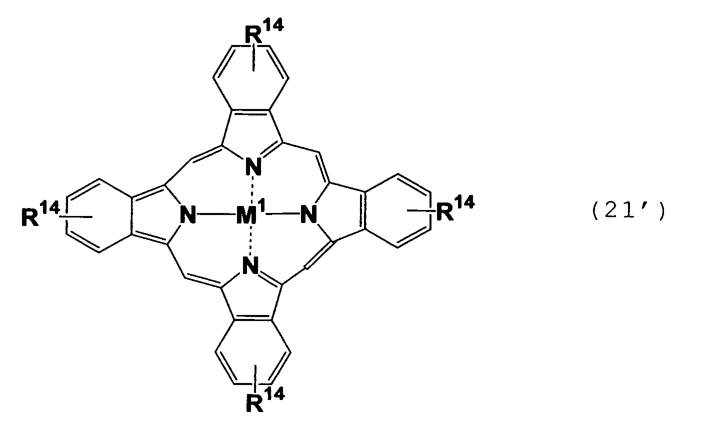

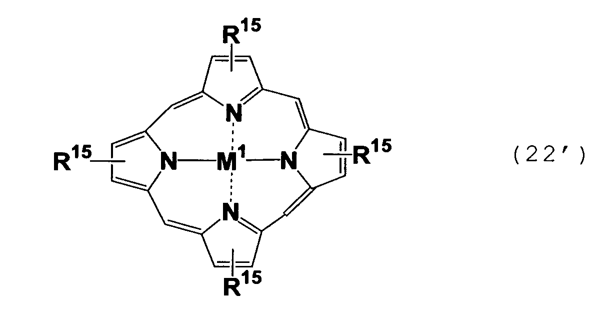

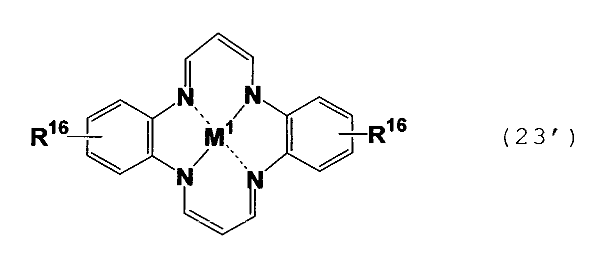

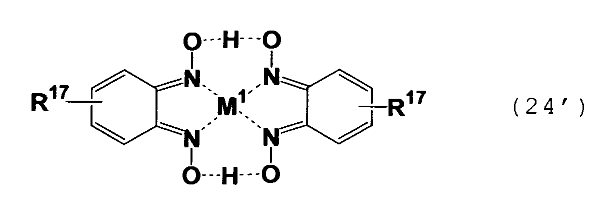

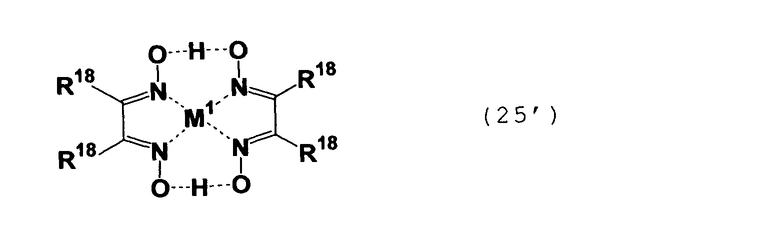

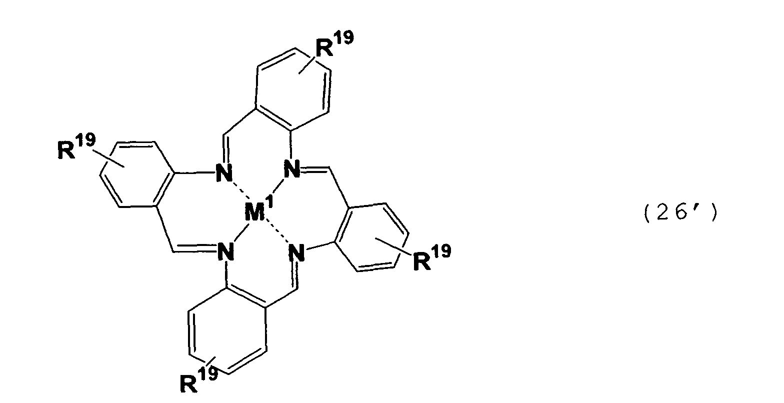

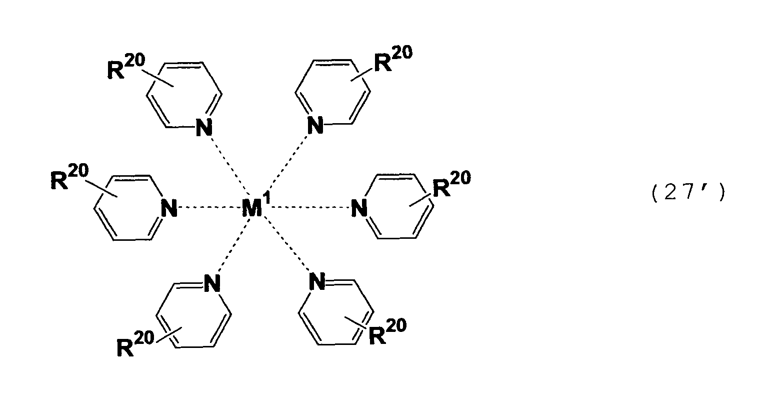

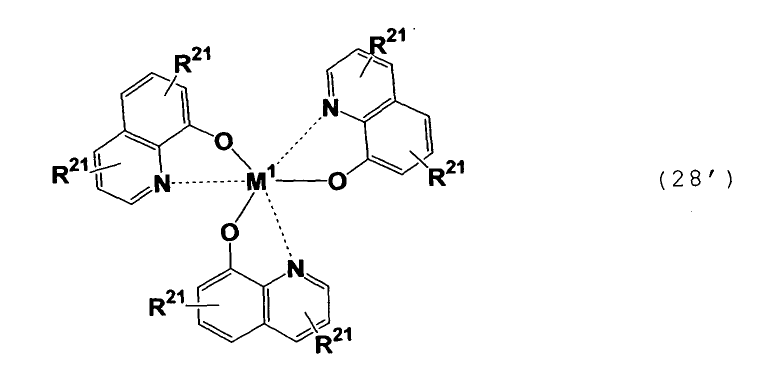

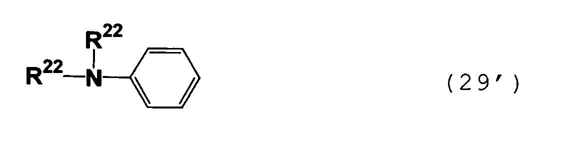

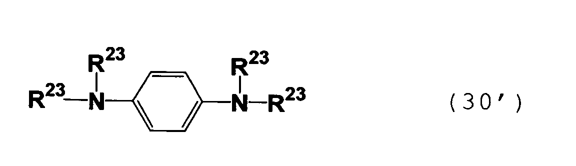

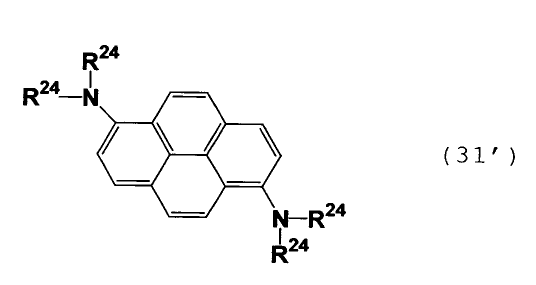

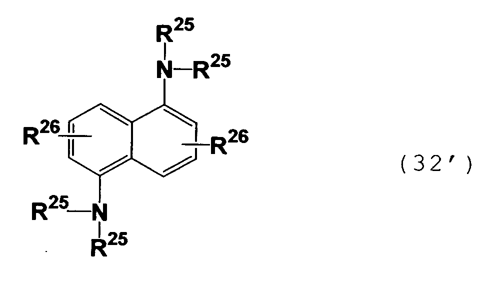

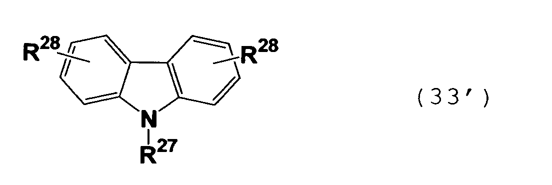

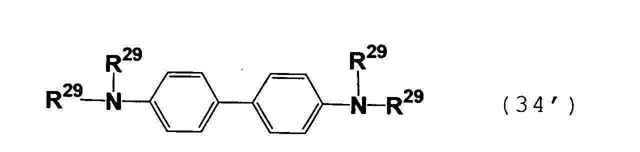

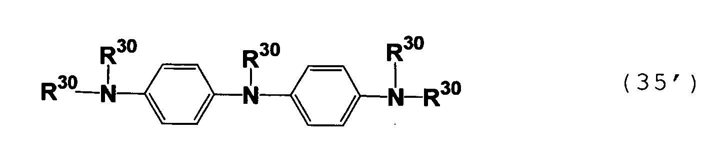

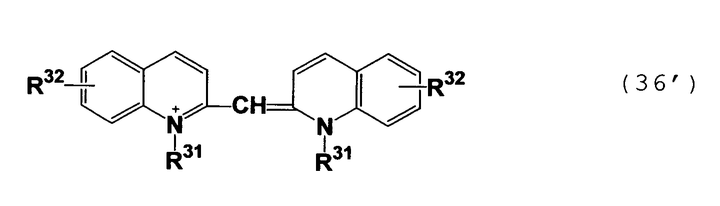

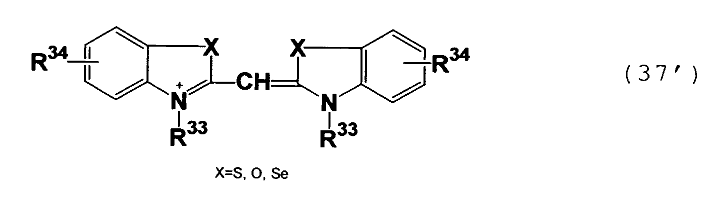

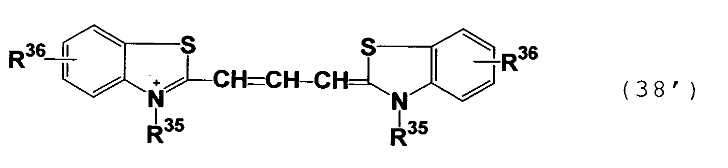

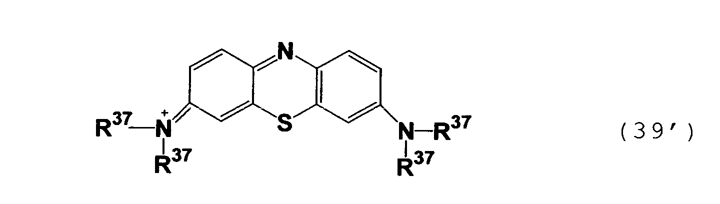

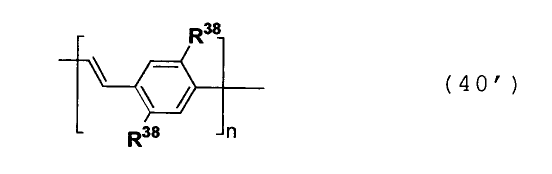

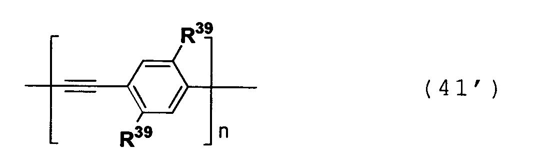

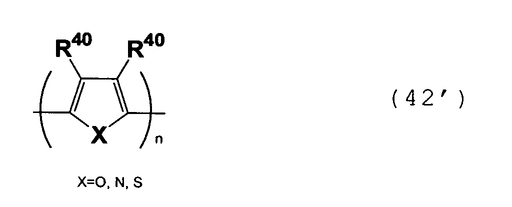

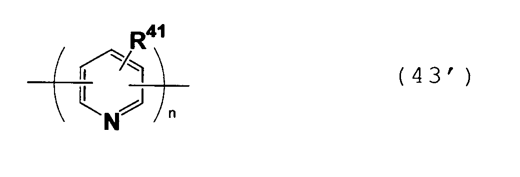

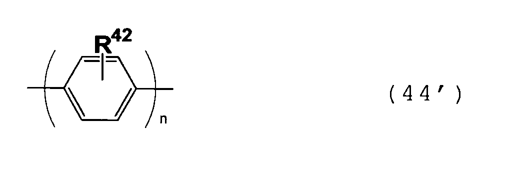

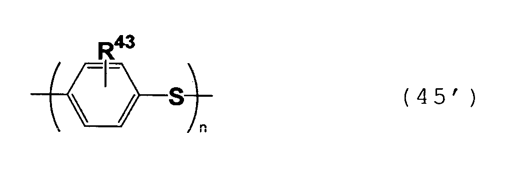

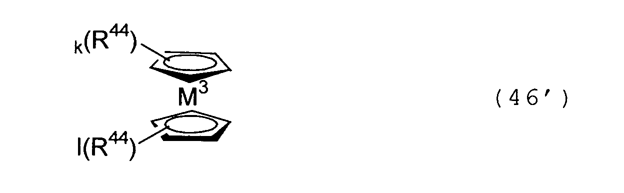

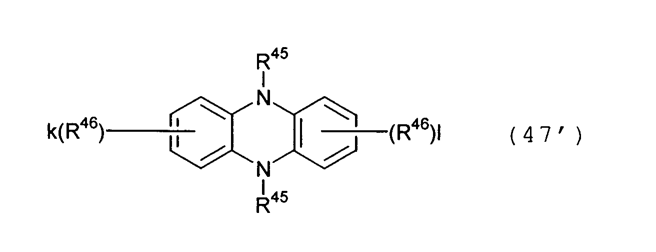

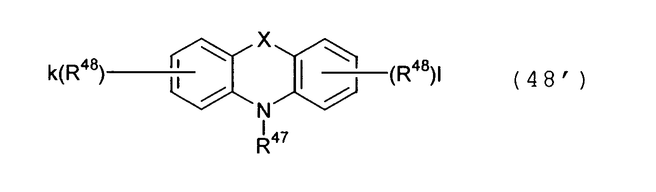

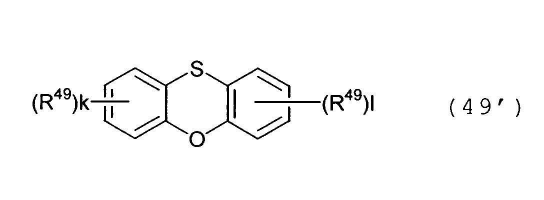

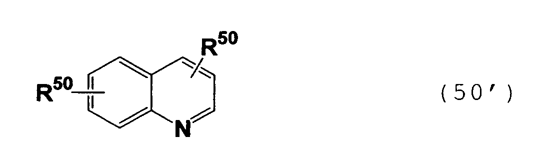

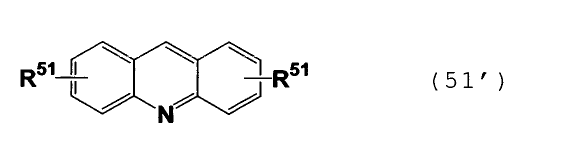

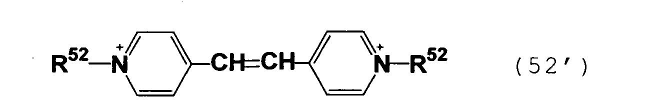

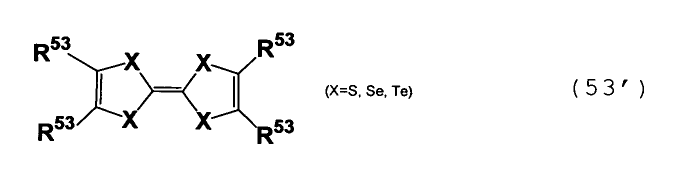

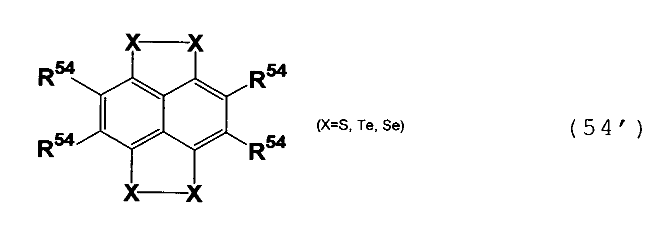

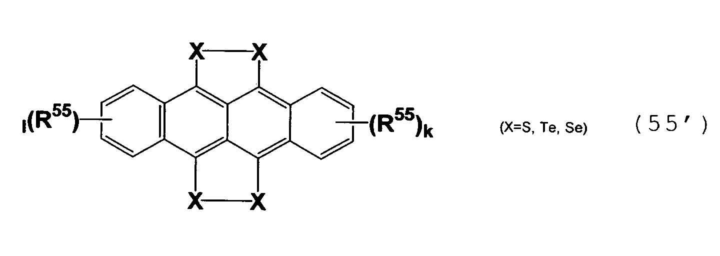

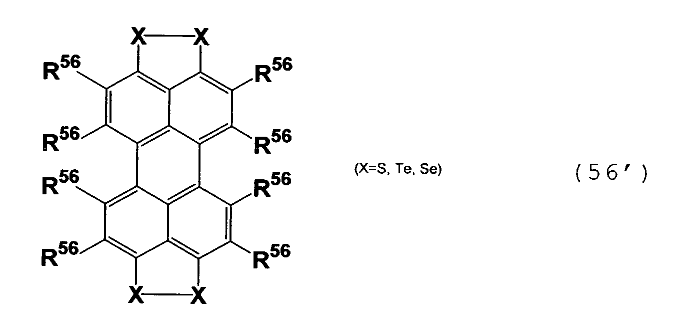

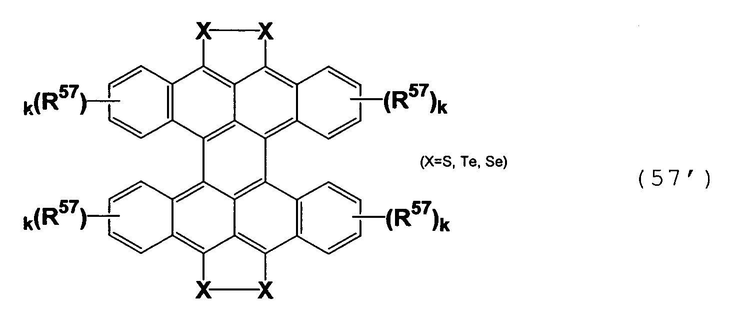

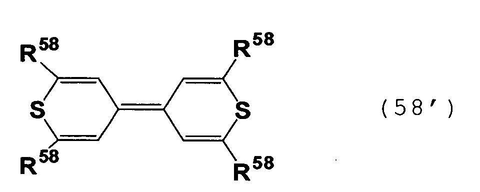

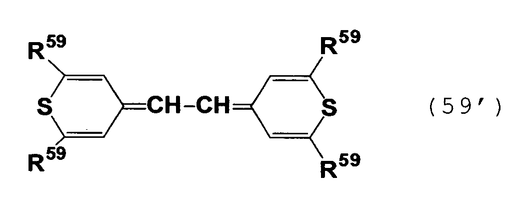

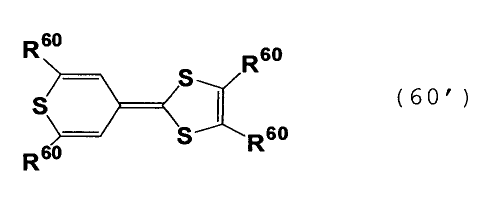

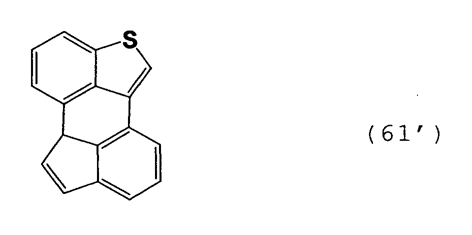

In formulas (1') to (61'), R¹ to R⁹ and R¹³ to R⁶⁰ may be the same or different from each other and are each independently hydrogen; a straight-chain or branched alkyl, alkenyl or alkoxyl group each having 1 to 10 carbon atoms; or an aryl, aralkyl, or aryloxy group having 6 to 12 carbon atoms. R⁴⁴ may be bonded to a cyclopentadienyl ring so as to form a ring or may form a group crosslinking cyclopentadienyl rings which are different from each other.

R¹⁰ to R¹² may be the same or different from each other and are each independently hydrogen; halogen; cyano, nitro, hydroxyl, amino, carboxyl, acetyl or holmyl group; a straight-chain or branched alkyl, alkenyl, alkoxyl, alkylthio or alkyloxycarbonyl group having 1 to 10 carbon atoms; or an aryl, aralkyl, or aryloxy group having 6 to 12 carbon atoms.

When a plurality of each R¹ to R⁶⁰ groups exist in one of the formulas, they may be the same or different from each other.

A⁻ and B⁻ may be the same or different from each other and are each independently a counter anion selected from the group consisting of halogen anions, ClO₄⁻, BF₄⁻, PF₆⁻, CH₃COO⁻, and CH₃(C₆H₄)SO₃⁻.

In the above formulas, m and n are each independently an integer of 1 to 1,000, preferably 2 to 500, and k and 1 indicate the number of each cyclic hydrocarbon group which can be substituted and are each usually an integer of 0 to 4.

M¹ is a metal atom such as Cu, Zn, Co, Fe, Ti, Mg, Ni, Mo, Os, and Ru. M² is an alkali metal or alkaline earth metal such as Li, Na, Mg, and Ca. M³ is Cr, Co, Fe, Mg, Ni, Os, Ru, V, X-Hf-Y, X-Mo-Y, X-Nb-Y, X-Ti-Y, X-V-Y or X-Zr-Y wherein X and Y are each independently hydrogen, halogen or an alkyl group having 1 to 12 carbon atoms and may be the same or different from each other.

Examples of the alkyl group include methyl, ethyl, propyl, i-propyl, butyl, s-butyl, t-butyl, pentyl, isopentyl, neopentyl, t-pentyl, hexyl, isohexyl, heptyl, octyl, nonyl, and decyl groups. Examples of the alkenyl group include vinyl, allyl, isopropenyl, butylenyl, pentylenyl, and hexenyl group. Examples of the alkoxy group include methoxy, ethoxy, propoxy, i-propoxy, butoxy, s-butoxy, t-butoxy, pentoxy, isopentoxy, neopentyloxy, t-pentyloxy, hexyloxy, isohexyloxy, heptyloxy, octyloxy, nonyloxy, and decyloxy groups. Examples of the aryl group include phenyl, xylyl, tolyl, cumenyl, and naphthyl groups. Examples of the aralkyl group include benzyl and trimethyl. Examples of the aryloxy group include phenoxy and tolyloxy groups.

Specific preferred examples of the compound having an electron-accepting molecular structure and the compound having an electron-donating molecular structure include polyacetylene, polypyrrole, polypyridine, poly-p-phenylene, poly-p-phenylenesulfide, polyphenylenevinylene, poly(2,5-dihexyloxy-1,4-phenylenevinylene), poly(2,5-dioctyloxy-1,4-phenylenevinylene), poly(2-methoxy-5-(2'-ethylhexyloxy)-1,4-phenylenevinylene), and compounds represented by formulas (69) to (131):

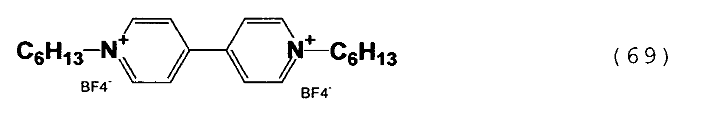

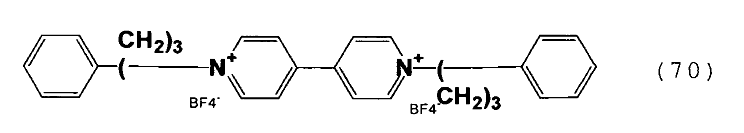

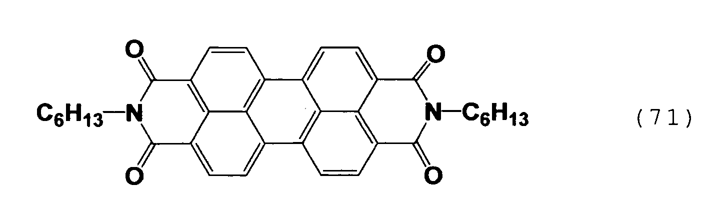

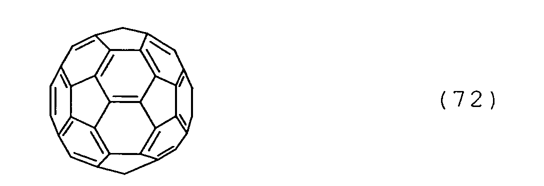

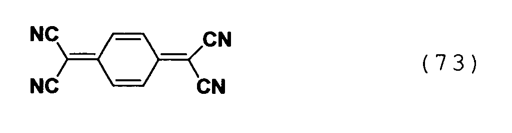

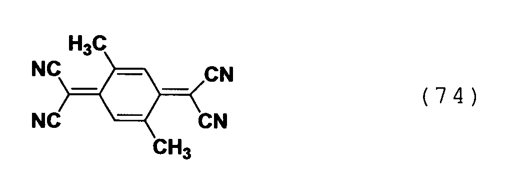

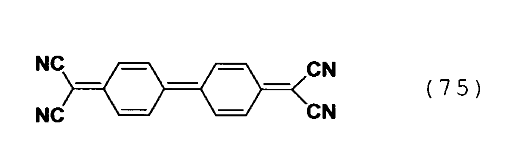

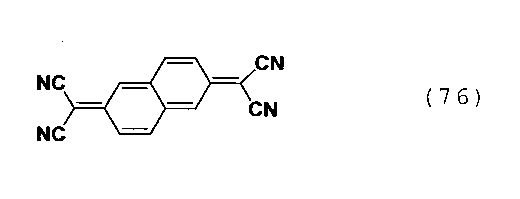

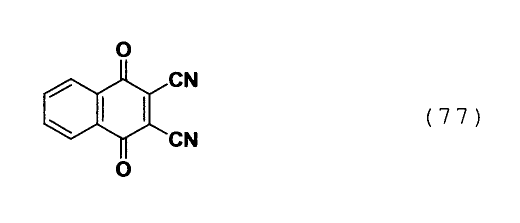

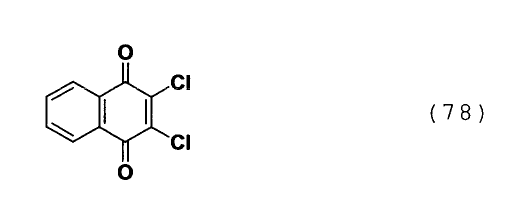

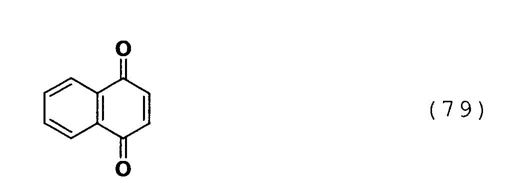

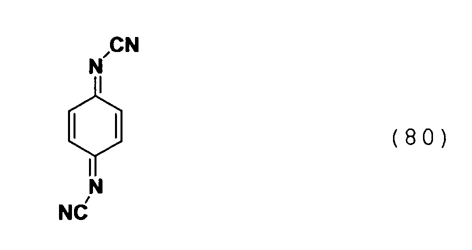

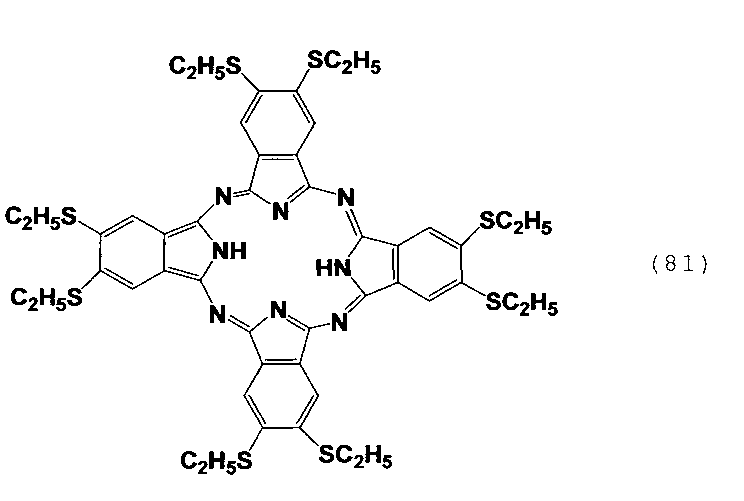

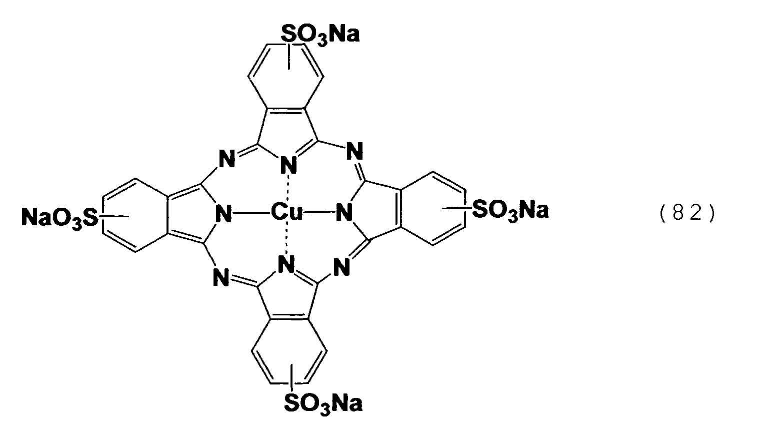

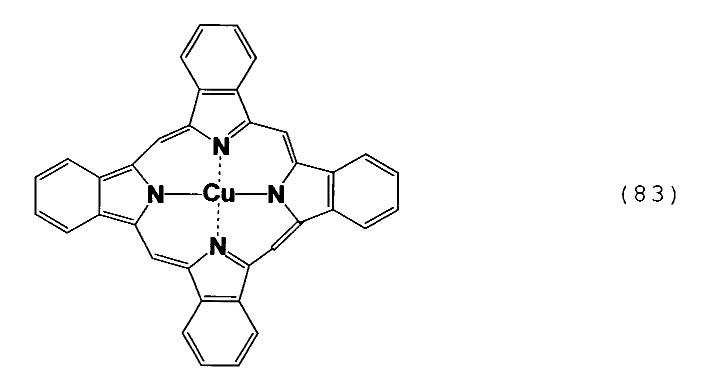

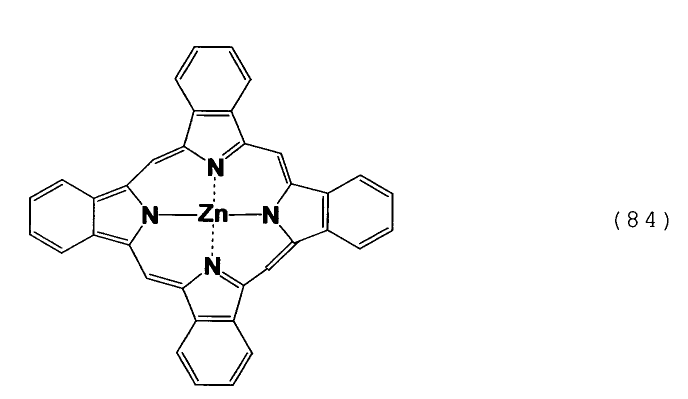

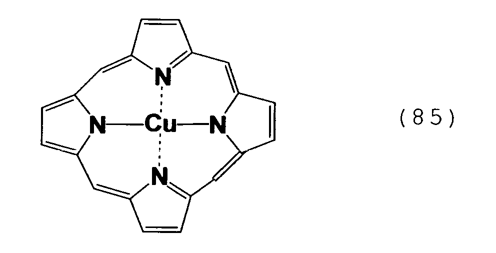

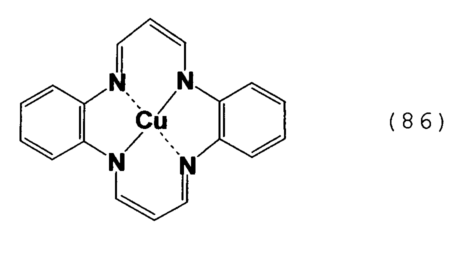

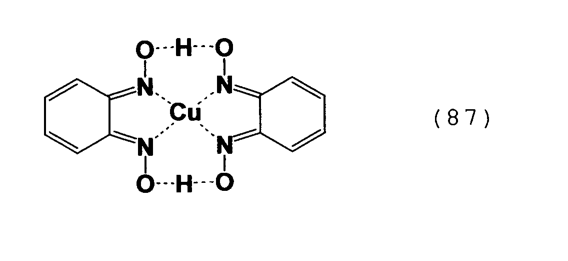

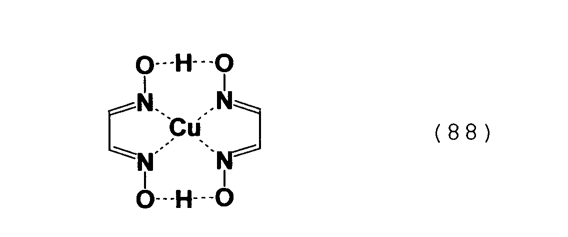

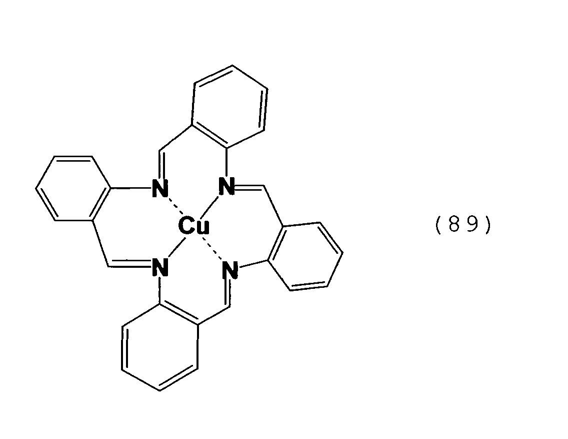

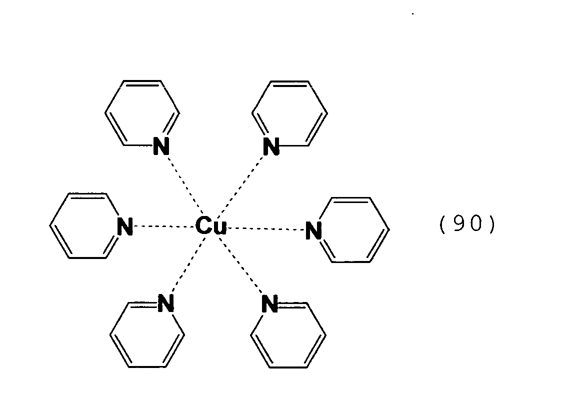

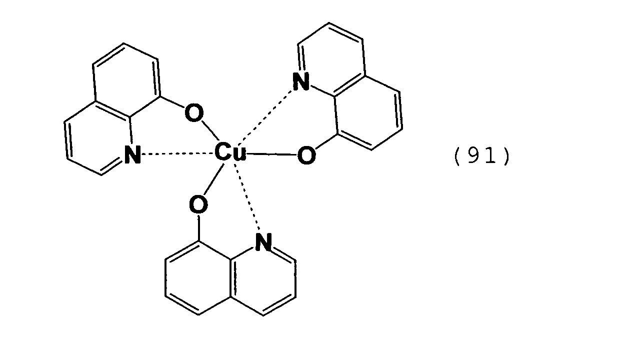

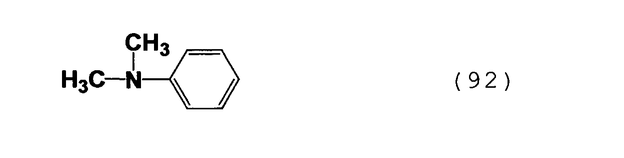

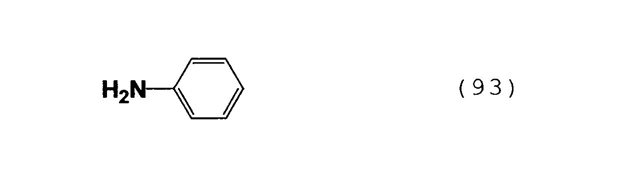

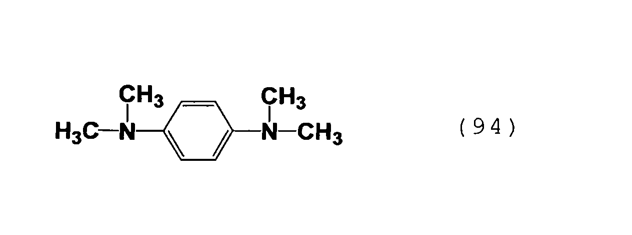

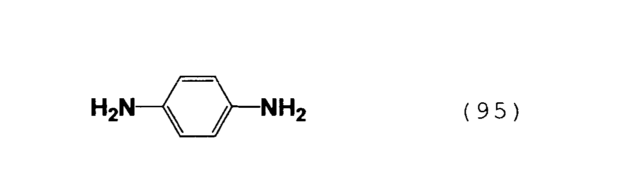

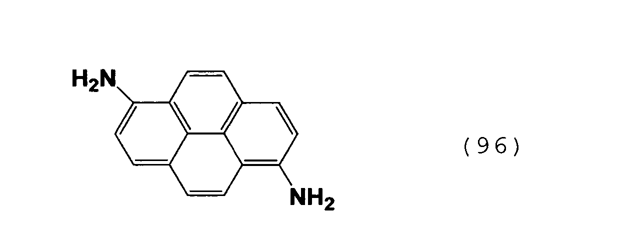

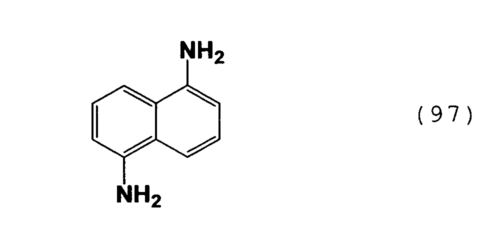

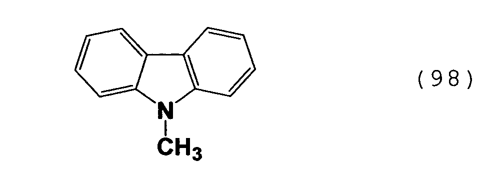

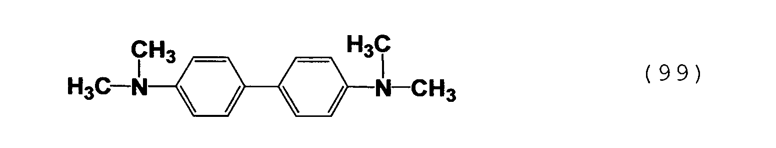

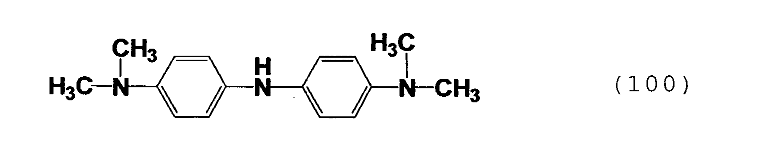

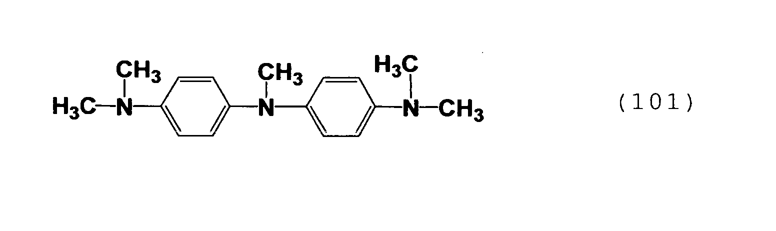

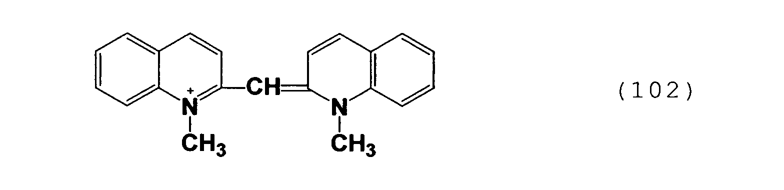

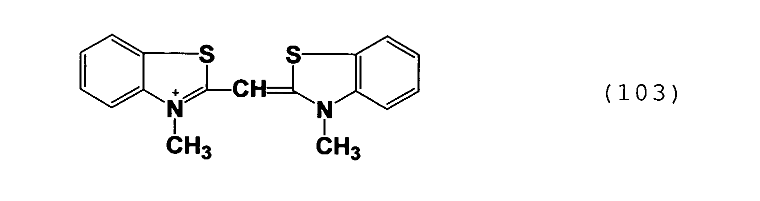

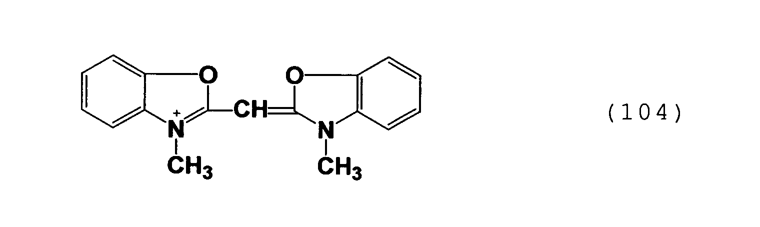

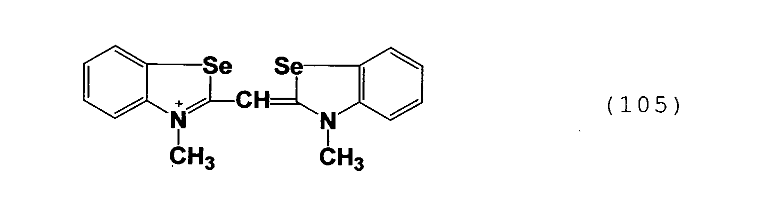

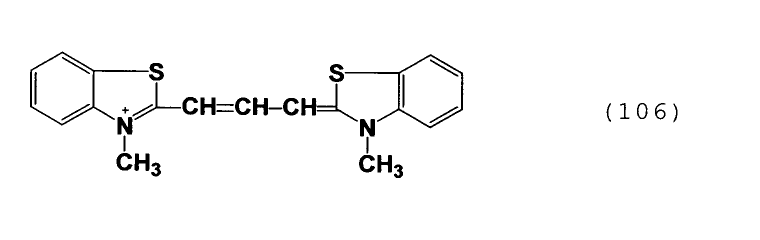

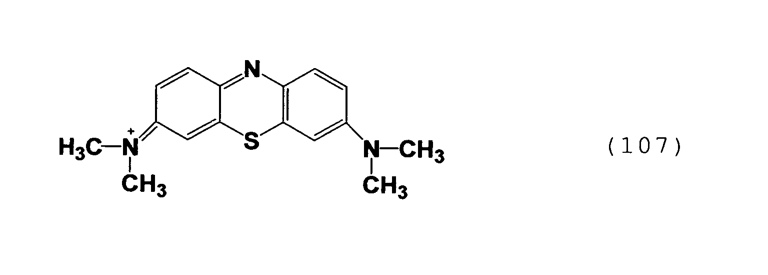

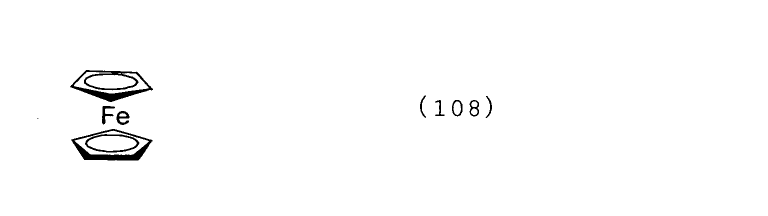

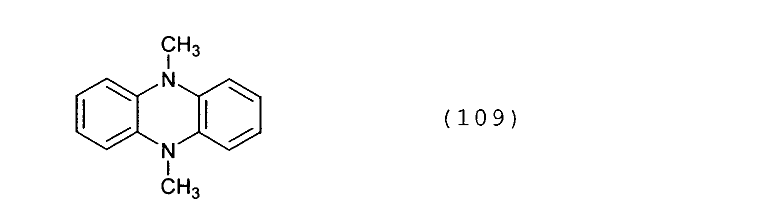

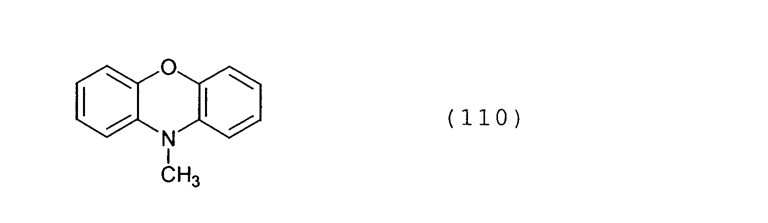

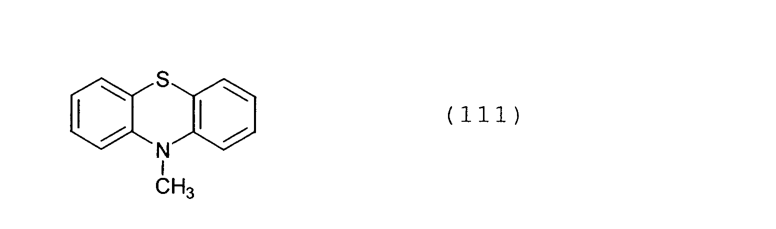

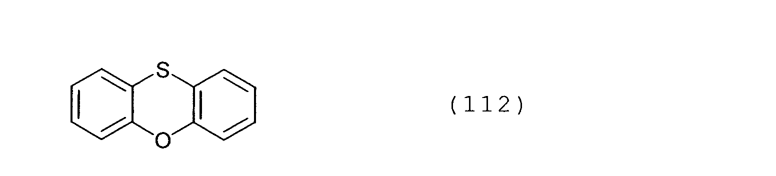

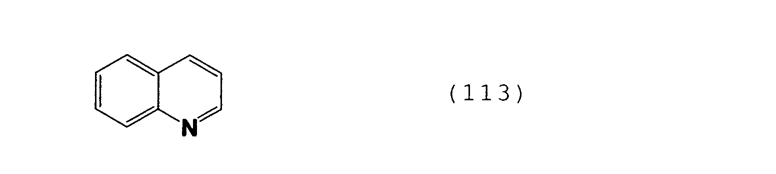

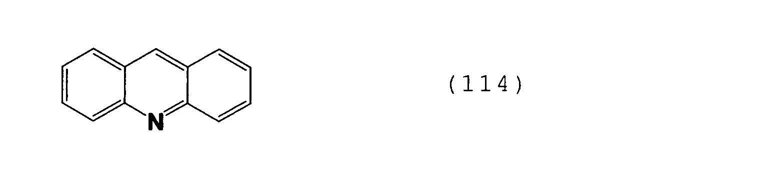

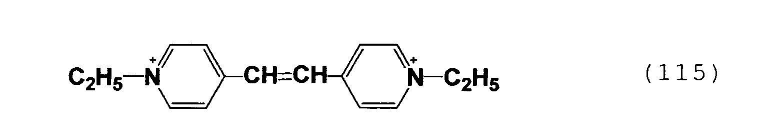

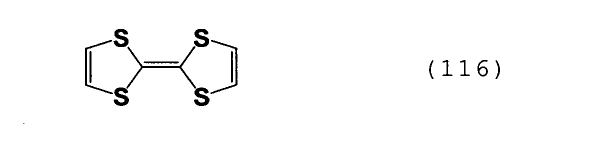

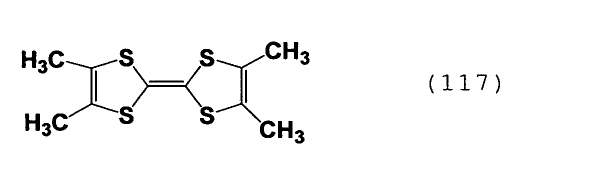

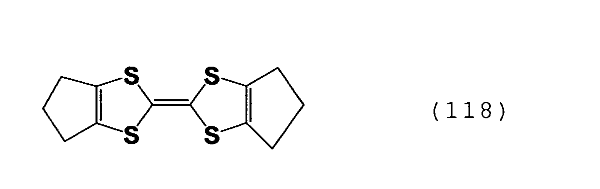

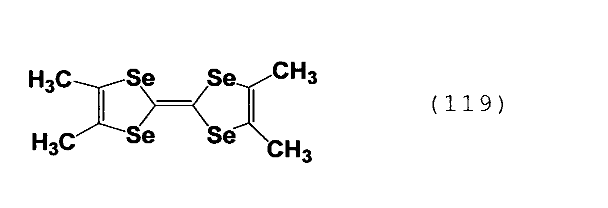

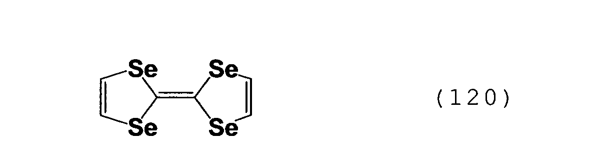

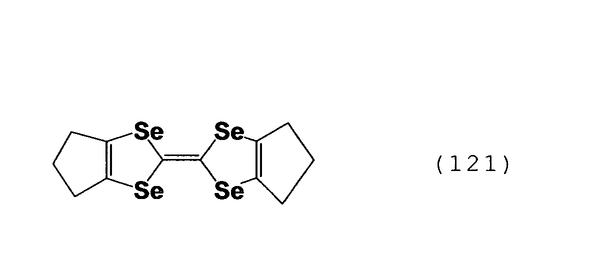

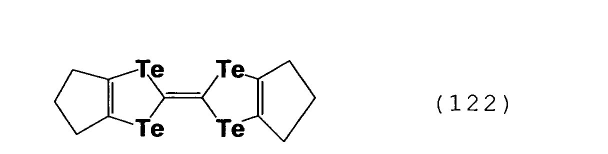

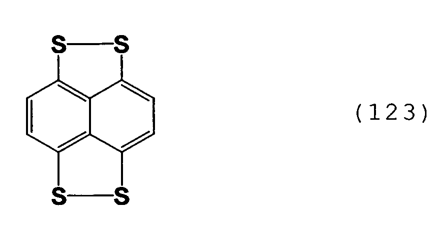

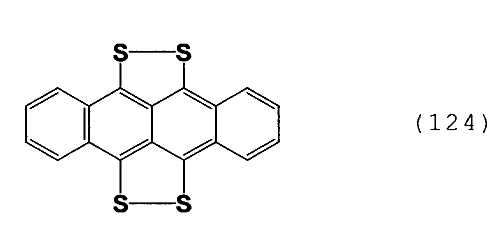

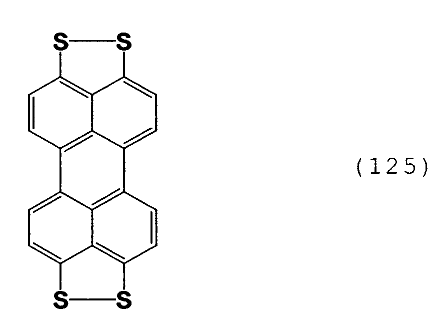

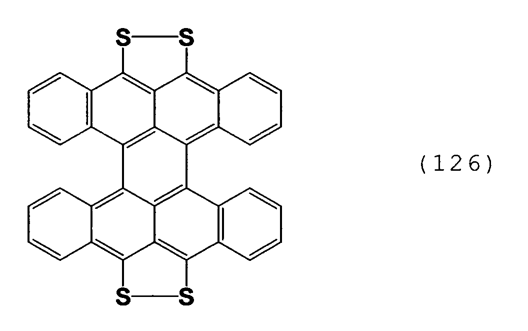

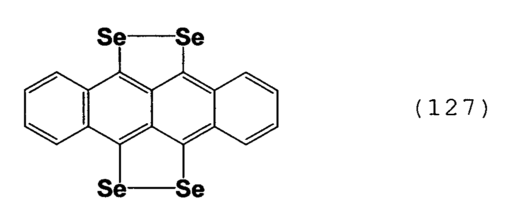

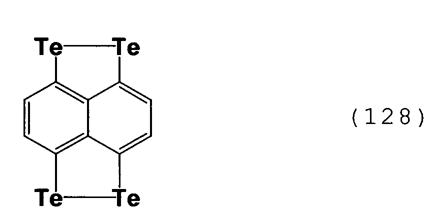

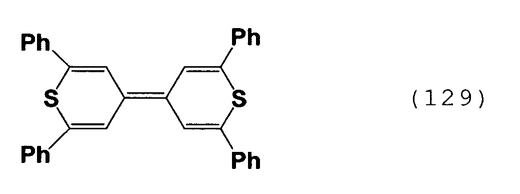

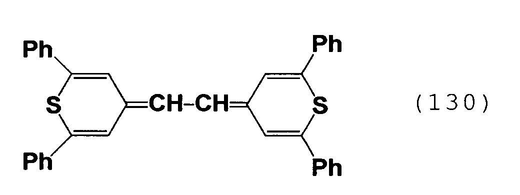

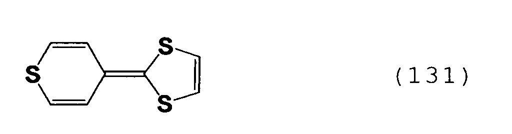

Preferred combinations of an electron-accepting molecular structure and an electron-donating molecular structure are a fullerene derivative (formula (3')) and a poly(phenylenevinylene)derivative (formula (40')); a cyano group-containing poly(phenylenevinylene)derivative (formula (4')) and a poly(phenylenevinylene)derivative (formula (40')); a viologen derivative (formula (1')) and an amine derivative (formulas (29') to (35')); a viologen derivative (formula (1')) and a metallocene derivative (formula (46')); a viologen derivative (formula (1')) and a polythiophene derivative (formula (42')); a viologen derivative (formula (1')) and a polypyrrole derivative (formula (42')); a viologen derivative (formula (1')) and a poly(phenylenevinylene)derivative (formula (40')); a perylene derivative (formula (2')) and a copper phthalocyanine derivative (formulas (20') to (22')); a perylene derivative (formula (2')) and a phthalocyanine derivative (formula (19))); a perylene derivative (formula (2')) and an amine derivative (formulas (29') to (35')); a perylene derivative (formula (2')) and a poly(phenylenevinylene)derivative (formula (40')); a perylene derivative (formula (2')) and a polythiophene derivative (formula (42')); a perylene derivative (formula (2')) and a polypyrrole derivative (formula (42')); a perylene derivative (formula (2')) and a metallocene derivative (formula (46')); a fullerene derivative (formula (3')) and a copper phthalocyanine derivative (formulas (20') to (22')); a fullerene derivative (formula (3')) and an amine derivative (formulas (29') to (35')); a fullerene derivative (formula (3')) and a polythiophene derivative (formula (42')); a fullerene derivative (formula (3')) and a polypyrrole derivative (formula (42')); a fullerene derivative (formula (3')) and a metallocene derivative (formula (46')); a cyano group-containing poly(phenylenevinylene)derivative (formula (4')) and an amine derivative (formulas (29') to (35')); a cyano group-containing poly(phenylenevinylene)derivative (formula (4')) and a copper phthalocyanine derivative (formulas (20') to (22')); a cyano group-containing poly(phenylenevinylene)derivative (formula (4')) and a polythiophene derivative (formula (42')); a cyano group-containing poly(phenylenevinylene)derivative (formula (4')) and a polypyrrole derivative (formula (42')); and a cyano group-containing poly(phenylenevinylene)derivative (formula (4')) and a metallocene group (formula (46')).

Compounds (A) having both an electron-donating molecular structure and an electron-accepting molecular structure, Compounds (B) having an electron-donating molecular structure and Compounds (C) having an electron-accepting molecular structure to be dispersed in the polymer forming the photoelectric converting layer preferably have electric conductivity. Whether or not these compounds have electric conductivity can be easily determined in a conventional manner. For example, whether or not these compounds have electric conductivity can be determined by measuring the electric conductivity in a conventional manner after the compound are doped. The compounds have an electric conductivity of generally 10⁻⁶ to 10⁶ S/cm and preferably 10⁻⁴ to 10⁵ S/cm.

The present invention is characterized in that the compound (A) having both an electron-donating molecular structure and an electron-accepting molecular structure and/or the compound (B) having an electron-donating molecular structure and the compound (C) having an electron-accepting molecular structure are dispersed in the polymer forming the photoelectric converting layer. No particular limitation is imposed on the method of dispersing these compounds. Therefore, the compounds may be dispersed by any method using a homogenizer, a ball mill, a beads mill, a sand mill, a twin roll mill, or a triple roll mill. Alternatively, the compounds may be dispersed or dissolved using a suitable solvent to an extent that the present invention is not prevented from achieving the object.

Further alternatively, after a polymer precursor and the compound (A) having both an electron-donating molecular structure and an electron-accepting molecular structure and/or the compound (B) having an electron-donating molecular structure and the compound (C) having an electron-accepting molecular structure are dispersed, the polymer precursor may be polymerized so as to be a polymer.

No particular limitation is imposed on an electrically conductive substrate on which the photoelectric converting layer is formed as long as it can be provided with electric conductivity by a suitable method. The electrically conductive substrate is usually produced by laminating a transparent electrode layer on a transparent substrate. No particular limitation is imposed on the transparent substrate. The material, thickness, size, and shape of the substrate can be properly selected depending on the purposes. For example, the substrate may be selected from colored or colorless glasses, wire glasses, glass blocks, and colored or colorless transparent resins. Specific examples are polyesters such as polyethylene terephthalate, polyamides, polysulfones, polyethersulfones, polyether ether ketones, polyphenylene sulfides, polycarbonates, polyimides, polymethyl methacrylates, polystyrenes, cellulose triacetates, and polymethyl pentenes. The term "transparent" used herein denotes a transmissivity of 10 to 100 percent. The substrates used herein are those having a smooth surface at ordinary temperature, which surface may be flat or curved or deformed with stress.

No particular limitation is imposed on the transparent electrode layer as long as it can achieve the purposes of the present invention. For example, the layer may be a metal film of gold, silver, chromium, copper, or tungsten or an electrically conductive film made of a metal oxide. Preferred examples of the metal oxide include tin oxide, zinc oxide, and those obtained by doping thereto trace amounts of components such as Indium Tin Oxide (ITO (In₂O₃:Sn)), Fluorine doped Tin Oxide (FTO (SnO₂:F)), and Aluminum doped Zinc Oxide (AZO (ZnO:Al)). The film thickness is usually from 100 to 5,000 nm and preferably from 500 to 3,000 nm. The surface resistance (resistivity) is properly selected depending on the use of the substrate in the present invention, but is usually from 0.5 to 500 Ω/sq and preferably from 2 to 50 Ω/sq.

No particular limitation is imposed on the method of forming the transparent electrode layer. The method is properly selected from any conventional methods depending on the type of the above-described metal or metal oxide used as the electrode layer. In general, the method is selected from vacuum deposition, ion plating, CVD, and sputtering. In any of the methods, the transparent electrode layer is desirously formed at a substrate temperature of 20 to 700°C.

If necessary, a semiconductor layer may be provided between the electrically conductive substrate and the photoelectric converting layer. Examples of materials used for producing the semiconductor layer include Bi₂S₃, CdS, CdSe, CdTe, CuInS₂, CuInSe₂, Fe₂O₃, GaP, GaAs, InP, Nb₂O₅, PbS, Si, SnO₂, TiO₂, WO₃, ZnO, and ZnS, among which preferred are CdS, CdSe, CuInS₂, CuInSe₂, Fe₂O₃, GaAs, InP, Nb₂O₅, PbS, SnO₂, TiO₂, WO₃, and ZnO. These materials may be used in combination. Particularly preferred are TiO₂, ZnO, SnO₂, and Nb₂O₅, while most preferred are TiO₂ and ZnO.

The semiconductor used in the present invention may be monocrystal or polycrystal. The crystal system may be selected from those of anatase, rutile, or brookite type among which preferred are those of anatase type. The semiconductor layer may be formed by any suitable conventional method.

The semiconductor layer may be obtained by coating a nanoparticle dispersant or a sol solution, of the above-mentioned semiconductor on the substrate by any conventional method. No particular limitation is imposed on the coating method. Therefore, the coating may be conducted by a method wherein the semiconductor layer is obtained in the form of film by casting; spin-coating; dip-coating; bar-coating; and various printing methods such as screen-printing.

The thickness of the semiconductor layer may be properly selected but is 0.5 µm or more and 50 µm or less and preferably 1 µm or more and 20 µm or less.

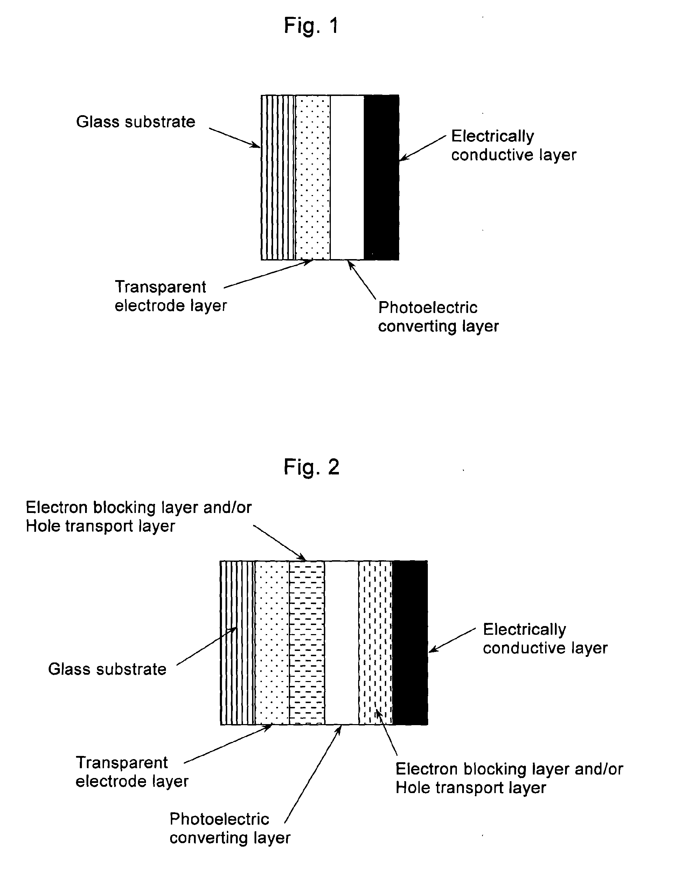

If necessary, the photoelectric converting device of the present invention may be provided with an electron blocking layer and/or a hole transport layer; a hole blocking layer and/or an electron transport layer; or a protection layer. The electron blocking layer and/or the hole transport layer are usually arranged between the positive pole and the photoelectric converting layer, while the hole blocking layer and/or the electron transport layer are usually arranged between the negative pole and the photoelectric converting layer. Fig. 2 shows an example of the layer structure.

Materials for forming the electron blocking layer and the hole transport layer may be any materials as long as they have the function to block photogenerated electrons or the function to transport photogenerated holes. Specific examples of such materials include electrically conductive polymers such as carbazole derivatives, triazole derivatives, oxazole derivatives, oxadiazole derivatives, imidazole derivatives, polyarylalkane derivatives, pyrazoline derivatives, pyrazolone derivatives, phenylenediamine derivatives, arylamine derivatives, amino-substituted-chalcone derivatives, styrylanthracene derivatives, fluorenone derivatives, hydrazone derivatives, stilbene derivatives, silazane derivatives, aromatic tertiary amine compounds, styrylamine compounds, aromatic dimethylidene-based compounds, porphyrin-based compounds, polysilane-based compounds, poly(N-vinylcarbazole)derivatives, aniline-based copolymers, thiophene oligomers and polythiophene.

The electron blocking layer and/or the hole transport layer may be of a single-layered structure composed of one or more of the materials exemplified above or a multi-layered structure composed of a plurality of layers each having the same or different composition.

The electron blocking layer and/or the hole transport layer may be formed by a method such as vacuum-deposition, LB method, ink jet method, and a coating method wherein any of the above-mentioned materials is dissolved or dispersed in a solvent and then coated by spin-coating, casting, or dip-coating.

When coating is used, a resin component may be dissolved or dispersed with any of the above materials thereby preparing a coating solution. Eligible resin components are polyvinyl chloride, polycarbonate, polystyrene, polymethylmethacrylate, polybutylmethacrylate, polyester, polysulfone, polyphenyleneoxide, polybutadiene, poly(N-vinylcarbazole), hydrocarbon resins, ketone resins, phenoxy resins, polyamide, ethyl cellulose, polyvinyl acetate, ABS resins, polyurethane, melamine resins, unsaturated polyester resins, alkyd resins, epoxy resins, and silicon resins. No particular limitation is imposed on the thickness of the electron blocking layer and the hole transport layer. However, the thickness is preferably from 1 nm to 5 µm, more preferably from 5 nm to 1 µm, and particularly preferably from 10 nm to 500 nm.

Materials for forming the hole blocking layer and the electron transport layer may be any materials as long as they have the function to block photogenerated holes or the function to transport photogenerated electrons. Specific examples of such materials include triazole derivatives, oxazole derivatives, oxadiazole derivatives, fluorenone derivatives, anthraquinodimethane derivatives, anthrone derivatives, diphenylquinone derivatives, thiopyrandioxide derivatives, carbodiimide derivatives, fluorenylidene methane derivatives, distyrylpyrazine derivatives, heterocyclic tetracarboxylic anhydrides such as naphthaleneperylene, phthalocyanine derivatives, and metal complexes such as those of 8-quinolinol derivatives and those having metal phthalocyanine, benzoxazole or benzothiazole as a ligand.

The hole blocking layer and/or the electron transport layer may be of a single-layered structure composed of one or more of the materials exemplified above or a multi-layered structure composed of a plurality of layers each having the same or different composition.

The hole blocking layer and/or the electron transport layer may be formed by a method such as vacuum-deposition, LB method, ink jet method, and a coating method wherein any of the above-mentioned materials is dissolved or dispersed in a solvent and then coated by spin-coating, casting, or dip-coating.

When coating is used, a resin component may be dissolved or dispersed with any of the above materials thereby preparing a coating solution. Eligible resin components are the same as those exemplified with respect to the electron blocking layer and/or the hole transport layer. No particular limitation is imposed on the thickness of the hole blocking layer and/or the electron transport layer. However, the thickness is preferably from 1 nm to 5 µm, more preferably from 5 nm to 1 µm, and particularly preferably from 10 nm to 500 nm.

The protection layer has a function to prevent objects such as moisture and oxygen facilitating deterioration of the device from entering thereinto. Eligible materials for the protection layer are metals such as In, Sn, Pb, Au, Cu, Ag, Al, Ti, and Ni; metal oxides such as MgO, SiO, SiO₂, Al₂O₃, GeO, NiO, CaO, BaO, Fe₂O₃, Y₂O₃, and TiO₂; metal fluorides such as MgF₂, LiF, AlF₃, and CaF₂; polyethylene; polypropylene, polymethylmethacrylate; polyimide; polyurea; polytetrafluoroethylene; polychlorotrifluoroethylene; polydichlorofluoroethylene; copolymers of chlorotrifluoroethylene and dichlorodifluoroethylene; copolymers obtained by copolymerizing a monomer mixture containing tetrafluoroethylene and at least one type of comonomer; fluorine-containing copolymers having a cyclic structure in the copolymer main chain; water-absorbing substances with an absorptivity of 1 percent or more; and moisture-proof substances with an absorptivity of 0.1 percent or less.

No particular limitation is imposed on the method of forming the protective layer. Therefore, the protective layer may be formed by any method such as sputtering, reactive sputtering, MBE (molecular beam epitaxy), cluster ion beam, ion plating, plasma polymerization (high-frequency excitation ion plating), plasma CVD, laser CVD, thermal CVD, gas source CVD, coating, and ink jet.

The electrically conductive film formed on the photoelectric converting layer may be formed from a metal such as aluminum, magnesium, gold, silver, platinum, indium, copper, and chromium, an alloy of magnesium and silver, an electrically conductive carbon, or a metal paste of silver, gold, or copper.

The method of forming the electrically conductive film is properly selected from conventional methods depending on the type of the above-exemplified materials. Examples of conventional methods include dry filming such as vacuum deposition, ion-plating, CVD, and sputtering; spin-coating; dip-coating; bar-coating; dispensing; and various printing methods such as screen-printing.

The film thickness is usually from 100 to 5,000 µm, preferably from 500 to 3,000 µm. The surface resistance (resistivity) is properly selected depending on the use of the photoelectric converting device of the present invention but is usually from 0.5 to 500 Ω/sq and preferably from 2 to 50 Ω/sq.

Alternatively, the photoelectric converting device of the present invention may be in the form of a laminate of a counter electrode substrate, the photoelectric converting layer comprising the compound (A) having both an electron donating molecular structure and an electron accepting molecular structure and/or the compound (B) having an electron donating molecular structure and the compound (C) having an electron accepting molecular structure dispersed in the polymer, and the electrically conductive substrate.

Examples of the counter electrode substrates include supporting substrates having electric conductivity per se and those obtained by forming an electrically conductive film on supporting substrates.

No particular limitation is imposed on the supporting substrate. The material, thickness, size, and shape of the substrate can be properly selected depending on the purposes. The supporting substrate may or may not have electrical conductivity and may be selected from metals such as gold and platinum, colored or colorless glasses, wire glasses, glass blocks, and colored or colorless transparent resins. Specific examples include polyesters such as polyethylene terephthalate, polyamides, polysulfones, polyethersulfones, polyether ether ketones, polyphenylene sulfides, polycarbonates, polyimides, polymethyl methacrylates, polystyrenes, cellulose triacetates, and polymethyl pentenes.

The substrates used herein are those having a smooth surface at ordinary temperature, which surface may be flat or curved or deformed with stress. The counter electrode substrates can be obtained by forming a film of a metal such as gold or platinum, In₂O₃:Sn, SnO₂:F, ZnO:Al by a conventional method such as vacuum-deposition, electron beam vacuum deposition, or sputtering.

When the counter electrode substrates are used, an electrolyte layer may be provided between the photoelectric converting layer and the counter electrode substrate. The electrolyte layer is an ion conductive material film containing at least one or more substances selected from (a) polymeric matrixes, (b) plasticizers, and (c) supporting electrolytes and exhibits reversible oxidation-reduction properties by (a) to (c) above or (d) redox agents.

No particular limitation is imposed on materials usable for the polymeric matrix as long as they can be formed in a solid or gelatinized state by itself or by addition of a plasticizer or a supporting electrolyte or a combination thereof. Polymeric compounds which have been conventionally used can be used.

Examples of such polymeric compounds exhibiting properties of the above-described polymeric matrix include homopolymers and copolymers of hexafluoropropylene, tetrafluoroethylene, trifluoroethylene, ethylene, propylene, acrylonitrile, vinylidene chloride, acrylic acid, methacrylic acid, methyl acrylate, ethyl acrylate, methyl methacrylate, and styrene polyfluorovinylidene. These polymers may be used individually or in combination.

The plasticizer may be any plasticizers as long as they are solvents which are generally used for electrochemical cells or electric cells. Specific examples are acetic anhydride, methanol, ethanol, tetrahydrofuran, propylene carbonate, nitromethane, acetonitrile, dimethylformamide, dimethylsulfoxide, hexamethylphosphoamide, ethylene carbonate, dimethoxyethane, γ-butyrolactone, γ-valerolactone, sulfolane, propionnitrile, glutaronitrile, tetrahydrofuran, adiponitrile, methoxyacetonitrile, dimethylacetoamide, methylpyrrolidinone, dioxolane, trimethyl phosphate, triethyl phosphate, tripropyl phosphate, ethyldimethyl phosphate, tributyl phosphate, tripentyl phosphate, trihexyl phosphate, triheptyl phosphate, trioctyl phosphate, trinonyl phosphate, tridecyl phosphate, tris(trifluoromethyl)phosphate, tris(pentafluoroethyl)phosphate, triphenylpolyethylene glycol phosphate, and polyethylene glycol. Particularly preferred examples include propylene carbonate, ethylene carbonate, dimethylsulfoxide, dimethoxyethane, acetonitrile, γ -butyrolactone, sulfolane, dioxolane, dimethylformamide, tetrahydrofuran, adiponitrile, methoxyacetonitrile, dimethylacetoamide, methylpyrrolidinone, trimethyl phosphate, and triethyl phosphate. These plasticizers may be used alone or in combination.

The supporting electrolyte may be salts, acids, alkalis, ordinary-temperature melting salts which are generally used in the field of electrochemistry or electric cells.

No particular limitation is imposed on the salts. For example, the salts may be inorganic ion salts such as alkali metal salts and alkaline earth metal salts, quaternary ammonium salts, cyclic quaternary ammonium salts, and quaternary phosphonium salts.
Particularly preferred are Li salts.

Specific examples of the salts include Li, Na, and K salts having a counter anion selected from halogen ions, SCN⁻, ClO₄⁻, BF₄⁻, CF₃SO₃⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻.

The salts may be any of quaternary ammonium salts having a counter anion selected from halogen ions, SCN⁻, ClO₄⁻, BF₄⁻, CF₃SO₃⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻, more specifically (CH₃)₄NBF₄, (C₂H₅)₄NBF₄, (n-C₄H₉)₄NBF₄, (C₂H₅)₄NBr, (C₂H₅)₄NClO₄, (n-C₄H₉)₄NClO₄, CH₃(C₂H₅)₃NBF₄, (CH₃)₂(C₂H₅)₂NBF₄, (CH₃)₄NSO₃CF₃, (C₂H₅)₄NSO₃CF₃, (n-C₄H₉)₄NSO₃CF₃, and those represented by the following formulas: 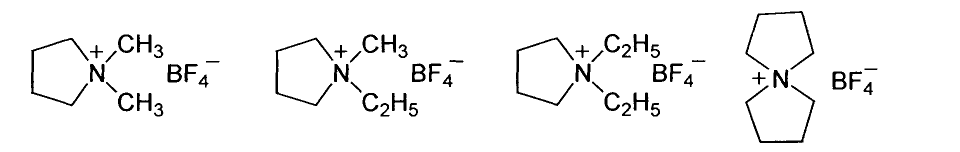 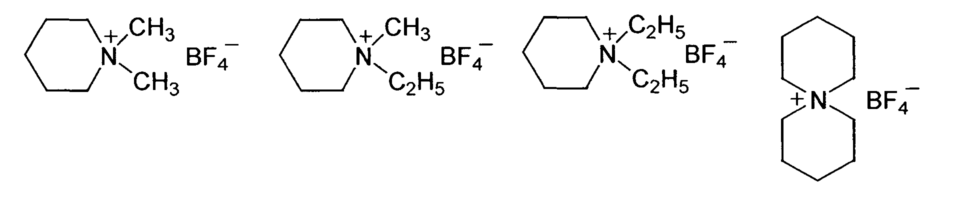 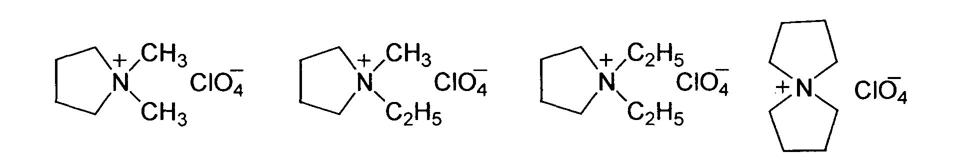 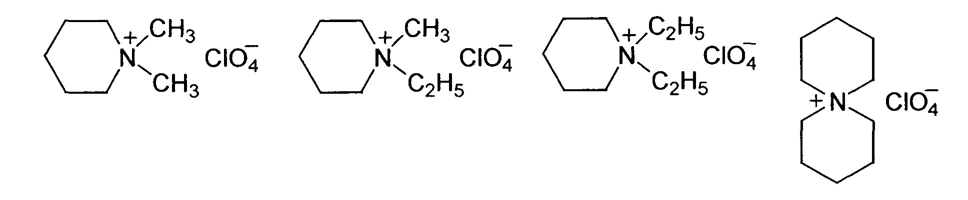 Furthermore, the salts may be any of phosphonium salts having a counter anion selected from halogen ions, SCN⁻, ClO₄⁻, BF₄⁻, CF₃SO₃⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻, more specifically (CH₃)₄PBF₄, (C₂H₅)₄PBF₄, (C₃H₇)₄PBF₄, and (C₄H₉)₄PBF₄.

Mixtures of these salts may also be used.

No particular limitation is imposed on the acids, which, therefore, may be inorganic acids or organic acids. Specific examples of the acids are sulfuric acid, hydrochloric acid, phosphoric acids, sulfonic acids, and carboxylic acids.

No particular limitation is imposed on the alkalis which, therefore, may be sodium hydroxide, potassium hydroxide, and lithium hydroxide.

No particular limitation is imposed on the ordinary-temperature melting salts. The term "ordinary-temperature melting salt" used herein denotes a salt comprising only ion pairs without solvent components, in a melted state (liquid state) at ordinary temperature, more specifically a salt comprising ion pairs which has a melting point of 20°C or below and will be in a liquid state at a temperature exceeding 20°C .

The ordinary-temperature melting salt may be used alone or in combination.

Examples of the ordinary-temperature melting salt include those represented by the following formulas: 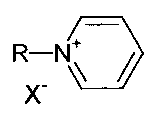 wherein R is an alkyl group having 2 to 20, preferably 2 to 10 carbon atoms and X⁻ is a counter anion selected from halogen ions, SCN⁻, ClO₄⁻, BF₄⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻; 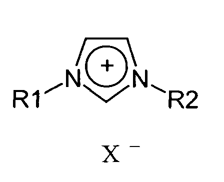 wherein R1 and R2 are each independently an alkyl group having 1 to 10 carbon atoms, preferably methyl or ethyl or an aralkyl group having 7 to 20, preferably 7 to 13 carbon atoms, preferably benzyl and may be the same or different from each other and X⁻ is a counter anion selected from halogen ions, SCN⁻, ClO₄⁻, BF₄⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻; and 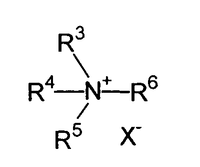 wherein R³, R⁴, R⁵, and R⁶ are each independently an alkyl group having one or more carbon atoms, preferably 1 to 6 carbon atoms, an aryl group having 6 to 12 carbon atoms such as phenyl, or a methoxymethyl group and may be the same or different from each other and X⁻ is a counter anion selected from halogen ions, SCN⁻, ClO₄⁻, BF₄⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻.

No particular limitation is imposed on the amount of the supporting electrolyte to be used. The supporting electrolyte may be contained in the electrolyte layer in an amount of usually 0.1 percent by mass or more, preferably 1 percent by mass or more, and more preferably 10 percent by mass or more and 70 percent by mass or less, preferably 60 percent by mass or less, and more preferably 50 percent by mass or less.

The redox agents used in the present invention will be described next.

The redox agents are those enabling a reversible electrochemical oxidation-reduction reaction and are not limited in type. The redox agent may be only either one of an oxidant or a reductant or a mixture thereof mixed at a suitable molar ratio.

Alternatively, a respective oxidation-reduction pair of the polymeric matrix, plasticizer, or supporting electrolyte may be added such that the polymeric matrix, plasticizer, or supporting electrolyte exhibits an electrochemical response. Examples of the materials capable of making polymeric matrix, plasticizer, or supporting electrolyte exhibit such properties include metallocenium salts such as ferrocenium having a counter anion selected from halogen ions, SCN⁻, ClO₄⁻, BF₄⁻, CF₃SO₃⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻ and halogens such as iodine, bromine, and chlorine.

The electrolyte layer used in the present invention may contain another component. Examples of the component include ultraviolet absorbing agents. Although not restricted, typical examples of the ultraviolet absorbing agents include organic ultraviolet absorbing agents such as compounds having a benzotriazole molecule structure or a benzophenone molecule structure.

Examples of the compound having a benzotriazole molecule structure include those represented by formula (132) below:

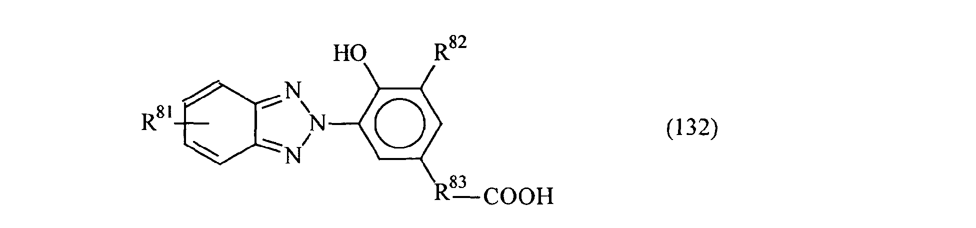

In formula (132), R⁸¹ is hydrogen, halogen or an alkyl group having 1 to 10, preferably 1 to 6 carbon atoms. Specific examples of the halogen are fluorine, chlorine, bromine, and iodine. Specific examples of the alkyl group include methyl, ethyl, propyl, i-propyl, butyl, t-butyl and cyclohexyl groups. R⁸¹ is usually substituted at the 4- or 5-position of the benzotriazole ring but the halogen atom and the alkyl group are usually located at the 4-position. R⁸² is hydrogen or an alkyl group having 1 to 10, preferably 1 to 6 carbon atoms. Examples of the alkyl group include methyl, ethyl, propyl, i-propyl, butyl, t-butyl, and cyclohexyl groups. R⁸³ is an alkylene or alkylidene group having 1 to 10, preferably 1 to 3 carbon atoms. Examples of the alkylene group include methylene, ethylene, trimethylene, and propylene groups. Examples of the alkylidene group include ethylidene and propylidene groups.

Specific examples of the compounds represented by formula (132) include
3-(5-chloro-2H-benzotriazole-2-yl)-5-(1,1-dimethylethyl)-4-hydroxy-benzene propanoic acid,
3-(2H-benzotriazole-2-yl)-5-(1,1-dimethylethyl)-4-hydroxy-benzene ethanoic acid,
3-(2H-benzotriazole-2-yl)-4-hydroxybenzene ethanoic acid,
3-(5-methyl-2H-benzotriazole-2-yl)-5-(1-methylethyl )-4-hydroxybenzene propanoic acid,
2-(2'-hydroxy-5'-methylphenyl)benzotriazole,
2- [2' -hydroxy-3',5'-bis (α,α-dimethylbenzyl) phenyl] benzotriazole, 2-(2'-hydroxy-3',
5'-di-t-butylphenyl)benzotriazol,
2-(2'-hydroxy-3'-t-butyl-5'-methylphenyl)-5-chloro benzotriazole, and
3-(5-chloro-2H-benzotriazole-2-yl)-5-(1,1-dimethyl ethyl)-4-hydroxy-benzene propanoic acid octylester.

Specific examples of the compound having a benzophenone molecule structure include those represented by the following formulas:

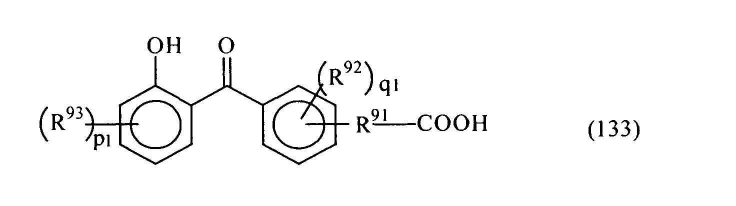

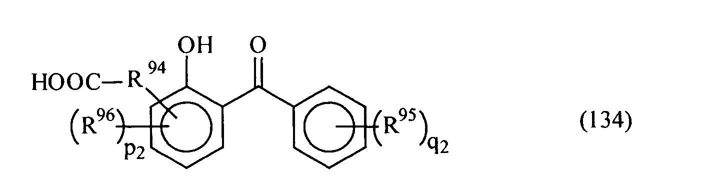

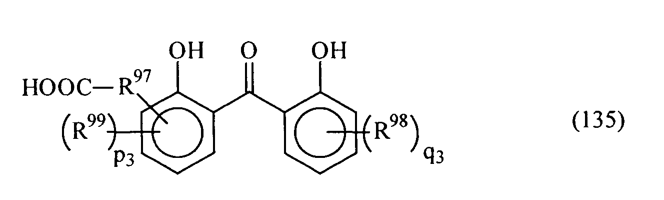

In formulas (133) to (135), R⁹², R⁹³, R⁹⁵, R⁹⁶, R⁹⁸, and R⁹⁹ may be the same or different from each other and are each independently a hydroxyl group or an alkyl or alkoxy group having 1 to 10, preferably 1 to 6 carbon atoms. Examples of the alkyl group include methyl, ethyl, propyl, i-propyl, butyl, t-butyl, and cyclohexyl groups. Specific examples of the alkoxy group are methoxy, ethoxy, propoxy, i-propoxy, and butoxy groups.

R⁹¹, R⁹⁴, and R⁹⁷ are each independently an alkylene or alkylidene group having 1 to 10, preferably 1 to 3 carbon atoms. Examples of the alkylene group include methylene, ethylene, trimethylene, and propylene groups. Examples of the alkylidene group include ethylidene and propylidene groups.

In the above formulas, p1, p2, p3, q1, q2, and q3 are each independently an integer of 0 to 3.

Preferred examples of the compounds having a benzophenone molecule structure, represented by formulas (133) to (135) include
2-hydroxy-4-methoxybenzophenone-5-carboxylic acid,
2,2'-dihydroxy-4-methoxybenzophenone-5-carboxylic acid, 4-(2-hydroxybenzoyl)-3-hydroxybenzen propanoic acid, 2,4-dihydroxybenzophenone,
2-hydroxy-4-methoxybenzophenone,
2-hydroxy-4-methoxybenzophenone-5-sulfonic acid,
2-hydroxy-4-n-octoxybenzophenone,
2,2'-dihydroxy-4,4'-dimethoxybenzophenone,
2,2',4,4'-tetrahydroxybenzophenone, and
2-hydroxy-4-methoxy-2'-carboxybenzophenone.

Needless to mention, two or more of these ultraviolet absorbing agents may be used in combination.

The use of the ultraviolet absorbing agent is optional. No particular limitation is imposed on the amount of the ultraviolet absorbing agent to be used. However, if the agent is used, it may be contained in the electrolyte layer in an amount of 0.1 percent by mass or more and preferably 1 percent by mass or more, and 20 percent by mass or less and preferably 10 percent by mass or less.

The electrolyte layer used in the present invention may be produced as an electrolyte film. The method of producing the electrolyte film will be described as follows.

The electrolyte film used in the present invention can be produced by forming a mixture obtained by blending any of arbitrary components such as a plasticizer, a supporting electrolyte, a redox agent, or an ultraviolet absorbing agent in a polymeric matrix component, into a film in a conventional manner. No particular limitation is imposed on the forming method. The film may be formed by extrusion, casting, or spin- or dip-coating.

Extrusion may be conducted in a conventional manner wherein a polymeric matrix is mixed with any of arbitrary components such as a plasticizer, a supporting electrolyte, a redox agent, an ultraviolet absorbing agent and formed into a film after being heat-melted.

Casting is conducted by mixing a polymeric matrix with any of arbitrary components such as a plasticizer, a supporting electrolyte, a redox agent, an ultraviolet absorbing agent, adjusting the viscosity of the mixture by adding a suitable diluent, and coating and drying the diluted mixture with a conventional coater normally used for casting thereby forming the mixture into a film. Examples of the coater include doctor coaters, blade coaters, rod coaters, knife coaters, reverse roll coaters, gravure coaters, spray coaters, and curtain coaters among which a suitable one is selected depending on the viscosity and film thickness.

Spin coating is conducted by mixing a polymeric matrix with any of arbitrary components such as a plasticizer, a supporting electrolyte, a redox agent, an ultraviolet absorbing agent, adjusting the viscosity of the mixture by adding a suitable diluent, and coating and drying the diluted mixture with a commercially available spin-coater thereby forming the mixture into a film.

Dip coating is conducted by mixing a polymeric matrix with any of arbitrary components such as a plasticizer, a supporting electrolyte, a redox agent, an ultraviolet absorbing agent, adjusting the viscosity of the mixture by adding a suitable diluent so as to obtain a solution of the mixture, dipping and lifting a suitable substrate therein, and drying the solution thereby forming the mixture into a film.

The electrolyte film obtained by any of the above-described methods exhibits an ionic conductivity of generally 1 x 10⁻⁷ S/cm or higher, preferably 1 x 10⁻⁶ S/cm or higher, and more preferably 1 x 10⁻⁵ S/cm or higher, at room temperature. The ionic conductivity can be determined by a conventional method such as complex impedance method.

No particular limitation is imposed on the thickness of the electrolyte film. The lower limit is usually 1 µm or more, preferably 10 µm or more, while the upper limit is usually 3 mm or less, preferably 1 mm or less.

### [Industrial Applicability]

The photoelectric converting device of the present invention is suppressed from the phase separation of the photoelectric converting layer and excellent in charge separation efficiency thereby enhancing the light utilizing efficiency and making possible highly efficient solar electric power generation.

Furthermore, the photoelectric converting device of the present invention can be relatively easily produced and is less in burden to the environment upon production or disposition.

### [Best Mode for Carrying out the Invention]

The present invention will be described in more details with reference to the following examples but is not limited thereto.

### (Example 1)

A 5 cm square ITO glass (a transparent electrically conductive glass obtained by forming an Sn-doped In₂O₃ film on a glass substrate) with a surface resistance of 10 Ω/sq was cleaned by alkali-washing and plasma-ozone washing. A coating solution was obtained by dispersing 200 mg of a compound both having an electron-accepting molecular structure and an electron-donating molecular structure, represented by the formula below in a solution obtained by dissolving 500 mg of polymethylmethacrylate (manufactured by FLUKA Ltd., Mw = about 200,000) in 10 g of chloroform. The coating solution was spin-coated on the ITO glass and dried sufficiently thereby obtaining a photoelectric converting layer. The thickness of the layer was about 4.5 µm. It was confirmed through an observation made on the surface of the layer that the film was uniform and clear. The photoelectric converting layer was left standing at a temperature of 80°C for 20 hours, but no particular change was observed.

Thereafter, aluminum was laminated at a film forming speed of 30 Å/s and a pressure of 1.33 x 10⁻³ Pa (1 x 10⁻⁵ Torr) over the photoelectric converting layer so as to be about 100 nm in thickness thereby obtaining a photoelectric converting device.

A light of a 100 W tungsten lump, uniformed through a diffuser was illuminated from the glass substrate side to the device, and the electric current thereof when the device was short-circuited was measured thereby confirming that a current of 4 µA was obtained and the device exhibited excellent photoelectric converting properties.

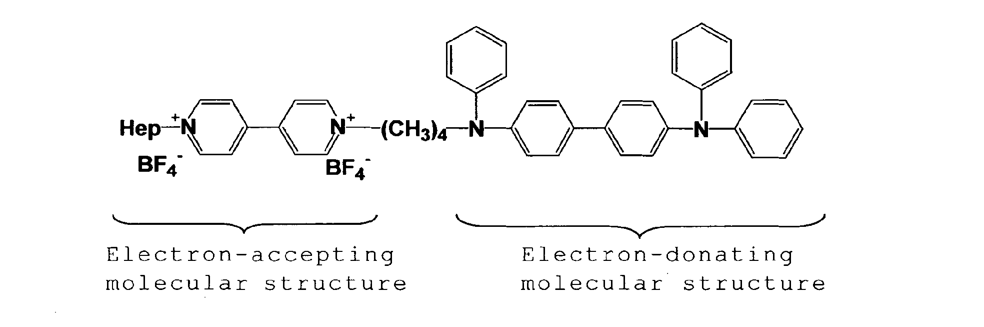

### (Example 2)

A 5 cm square ITO glass (a transparent electrically conductive glass obtained by forming an Sn-doped In₂O₃ film on a glass substrate) with a surface resistance of 10 Ω/sq was cleaned by alkali-washing and plasma-ozone washing. A coating solution was obtained by dispersing 200 mg of fullerene (C₆₀) as a compound having an electron-accepting molecular structure and 100 mg of Compound (a) (poly(2,5-dihexyloxy-1,4-phenylenevinylene) manufactured by ALDRICH Ltd.) indicated below as a compound having an electron-donating molecular structure in a solution obtained by dissolving 500 mg of polymetylmethacrylate (manufactured by FLUKA Ltd., Mw = about 200,000) in 10 g of chloroform. The coating solution was spin-coated on the ITO glass and dried sufficiently thereby obtaining a photoelectric converting layer. The thickness of the layer was about 5 µm. It was confirmed through an observation made on the surface of the layer that the film was uniform and clear. The photoelectric converting layer was left standing at a temperature of 80°C for 20 hours, but no particular change was observed.

Thereafter, aluminum was laminated at a film forming speed of 30 Å/s and a pressure of 1.33 x 10⁻³ Pa (1 x 10⁻⁵ Torr) over the photoelectric converting layer so as to be about 100 nm in thickness thereby obtaining a photoelectric converting device.

A light of a 100 W tungsten lump, uniformed through a diffuser was illuminated from the glass substrate side to the device, and the electric current thereof when the device was short-circuited was measured thereby confirming that a current of 2.1 µA was obtained and the device exhibited excellent photoelectric converting properties.

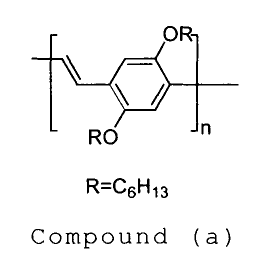

### (Example 3)

Poly[(3,4-ethylenedioxy)-2,5-thiophene]· polystyrene sulfonate dispersant (manufactured by Bayer Ltd under the name of "Baytron P", solid content : 1.3 %) was spin-coated on a 5 cm square ITO glass (a transparent electrically conductive glass obtained by forming an Sn-doped In₂O₃ film on a glass substrate) with a surface resistance of 10 Ω/sq having been cleaned by alkali-washing and plasma-ozone washing and vacuum-dried at a temperature of 150°C for 2 hours thereby forming a coating layer with a thickness of 100 nm. On the coated layer was spin-coated a coating solution obtained by dispersing 200 mg of C₆₀ as a compound having an electron-accepting molecular structure and 100 mg of Compound (a) used in Example 2 as a compound having an electron-donating molecular structure in a solution obtained by dissolving 500 mg of polymetylmethacrylate (manufactured by FLUKA Ltd., Mw = about 200, 000) in 10 g of chloroform. The coating solution was dried sufficiently thereby obtaining a photoelectric converting layer. The thickness of the layer was about 5 µm. It was confirmed through an observation made on the surface of the layer that the film was uniform and clear. The photoelectric converting layer was left standing at a temperature of 80°C for 20 hours, but no particular change was observed.

Thereafter, aluminum was laminated at a film forming speed of 30 Å/s and a pressure of 1.33 x 10⁻³ Pa (1 x 10⁻⁵ Torr) over the photoelectric converting layer so as to be about 100 nm in thickness thereby obtaining a photoelectric converting device.

A light of a 100 W tungsten lump, uniformed through a diffuser was illuminated from the glass substrate side to the device, and the electric current thereof when the device was short-circuited was measured thereby confirming that a current of 3.5 µA was obtained and the device exhibited excellent photoelectric converting properties.

### (Example 4)

Poly[(3,4-ethylenedioxy)-2,5-thiophene]· polystyrene sulfonate dispersant (manufactured by Bayer Ltd under the name of "Baytron P", solid content : 1.3 %) was spin-coated on a 5 cm square ITO glass (a transparent electrically conductive glass obtained by forming an Sn-doped In₂O₃ film on a glass substrate) with a surface resistance of 10 Ω/sq having been cleaned by alkali-washing and plasma-ozone washing and vacuum-dried at a temperature of 150°C for 2 hours thereby forming a coating layer with a thickness of 100 nm. On the coated layer was spin-coated a coating solution obtained by dispersing 200 mg of Compound (b) having both an electron-accepting molecular structure and an electron-donating molecular structure, represented by the formula given below in a solution obtained by dissolving 500 mg of (poly(2,5-dihexyloxy-1,4-phenylenevinylene) manufactured by ALDRICH Ltd.) in 10 g of chloroform. The coating solution was dried sufficiently thereby obtaining a photoelectric converting layer. The thickness of the layer was about 5 µm. It was confirmed through an observation made on the surface of the layer that the film was uniform and clear. The photoelectric converting layer was left standing at a temperature of 80°C for 20 hours, but no particular change was observed.

Thereafter, aluminum was laminated at a film forming speed of 30 Å/s and a pressure of 1.33 x 10⁻³ Pa (1 x 10⁻⁵ Torr) over the photoelectric converting layer so as to be about 100 nm in thickness thereby obtaining a photoelectric converting device.

A light of a 100 W tungsten lump, uniformed through a diffuser was illuminated from the glass substrate side to the device, and the electric current thereof when the device was short-circuited was measured thereby confirming that a current of 4.2 µA was obtained and the device exhibited excellent photoelectric converting properties.

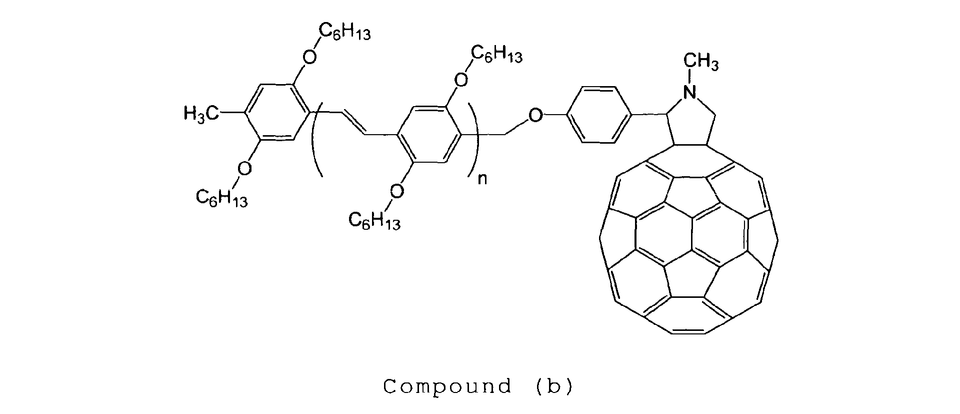

### (Example 5)

Poly[(3,4-ethylenedioxy)-2,5-thiophene]· polystyrene sulfonate dispersant (manufactured by Bayer Ltd under the name of "Baytron P", solid content : 1.3 %) was spin-coated on a 5 cm square ITO glass (a transparent electrically conductive glass obtained by forming an Sn-doped In₂O₃ film on a glass substrate) with a surface resistance of 10 Ω/sq having been cleaned by alkali-washing and plasma-ozone washing and vacuum-dried at a temperature of 150°C for 2 hours thereby forming a coating layer with a thickness of 100 nm. On the coated layer was spin-coated a coating solution obtained by dispersing 200 mg of Compound (c) having an electron-accepting molecular structure represented by the formula given below and 100 mg of Compound (d) having an electron-donating molecular structure, represented by the formula given below in a solution obtained by dissolving 500 mg of (poly(2,5-dihexyloxy-1,4-phenylenevinylene) manufactured by ALDRICH Ltd.) in 10 g of chloroform. The coating solution was dried sufficiently thereby obtaining a photoelectric converting layer. The thickness of the layer was about 5 µm. It was confirmed through an observation made on the surface of the layer that the film was uniform and clear. The photoelectric converting layer was left standing at a temperature of 80°C for 20 hours, but no particular change was observed.

Thereafter, aluminum was laminated at a film forming speed of 30 Å/s and a pressure of 1.33 x 10⁻³ Pa (1 x 10⁻⁵ Torr) over the photoelectric converting layer so as to be about 100 nm in thickness thereby obtaining a photoelectric converting device.

A light of a 100 W tungsten lump, uniformed through a diffuser was illuminated from the glass substrate side to the device, and the electric current thereof when the device was short-circuited was measured thereby confirming that a current of 4.5 µA was obtained and the device exhibited excellent photoelectric converting properties.

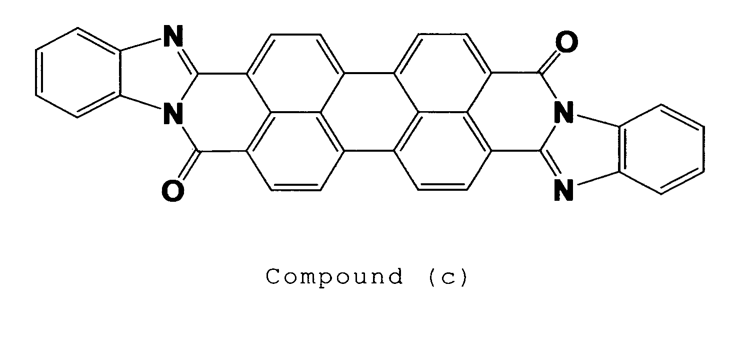

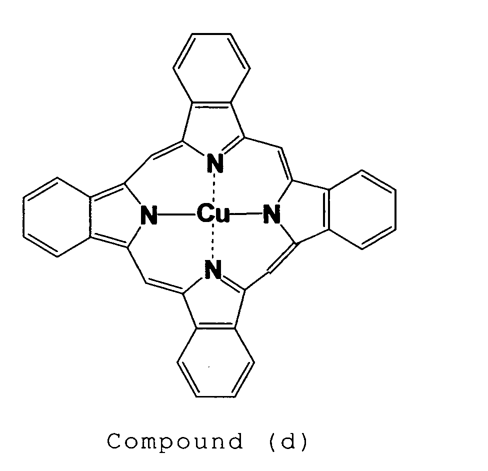

### [Brief Description of the Drawings]

Fig. 1 shows an example of a layer structure of a photoelectric converting device according to the present invention.
Fig. 2 shows another example of a layer structure of a photoelectric converting device according to the present invention.

## Claims

1. A photoelectric converting device which has a photoelectric converting layer comprising an organic compound (A) having both an electron donating molecular structure and an electron accepting molecular structure dispersed in a polymer.

2. A photoelectric converting device which has a photoelectric converting layer comprising an organic compound (B) having an electron donating molecular structure and an organic compound (C) having an electron accepting molecular structure, dispersed in a polymer.

3. The photoelectric converting device according to claim 1 wherein said polymer is an electrically conductive polymeric compound.

4. The photoelectric converting device according to claim 2 wherein said polymer is an electrically conductive polymeric compound.
